(19) Europäisches Patentamt
European Patent Office
Office européen des brevets

(11) **EP 3 595 159 B1**

(12) **EUROPEAN PATENT SPECIFICATION**

(45) Date of publication and mention
of the grant of the patent:
**18.08.2021 Bulletin 2021/33**

(21) Application number: **18764704.5**

(22) Date of filing: **28.02.2018**

(51) Int Cl.:
*G01R 31/52* (2020.01)          *H02P 29/024* (2016.01)
*H02P 27/06* (2006.01)          *H02M 1/32* (2007.01)
*H02M 7/797* (2006.01)          *H02M 7/5387* (2007.01)
*H02M 5/458* (2006.01)          *H02H 7/122* (2006.01)
*G01R 31/34* (2020.01)

(86) International application number:
**PCT/JP2018/007388**

(87) International publication number:
**WO 2018/163922 (13.09.2018 Gazette 2018/37)**

(54) **POWER CONVERSION DEVICE AND GROUND FAULT LOCATION DETERMINATION METHOD**

STROMUMWANDLUNGSVORRICHTUNG UND VERFAHREN ZUR BESTIMMUNG DES ORTES VON ERDSCHLÜSSEN

DISPOSITIF DE CONVERSION DE PUISSANCE ET PROCÉDÉ DE DÉTERMINATION D'EMPLACEMENT DE DÉFAUT DE MISE À LA TERRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.03.2017 JP 2017042334**

(43) Date of publication of application:
**15.01.2020 Bulletin 2020/03**

(73) Proprietor: **Hitachi Industrial Equipment Systems Co., Ltd.**
**Tokyo 101-0022 (JP)**

(72) Inventors:
• **KAGEYAMA Hiroshi**
**Tokyo 100-8280 (JP)**
• **UCHINO Yoshihiro**
**Tokyo 101-0022 (JP)**
• **SASAKI Yasushi**
**Tokyo 101-0022 (JP)**

(74) Representative: **Mewburn Ellis LLP**
**Aurora Building**
**Counterslip**
**Bristol BS1 6BX (GB)**

(56) References cited:
JP-A- H0 666 901          JP-A- H06 233 450
JP-A- 2011 188 653          JP-A- 2014 236 533
JP-A- 2015 056 918          JP-A- 2016 226 243

**Description**

Technical Field

The present invention relates to a power conversion device and a short circuit location determining method using the power conversion device.

Background Art

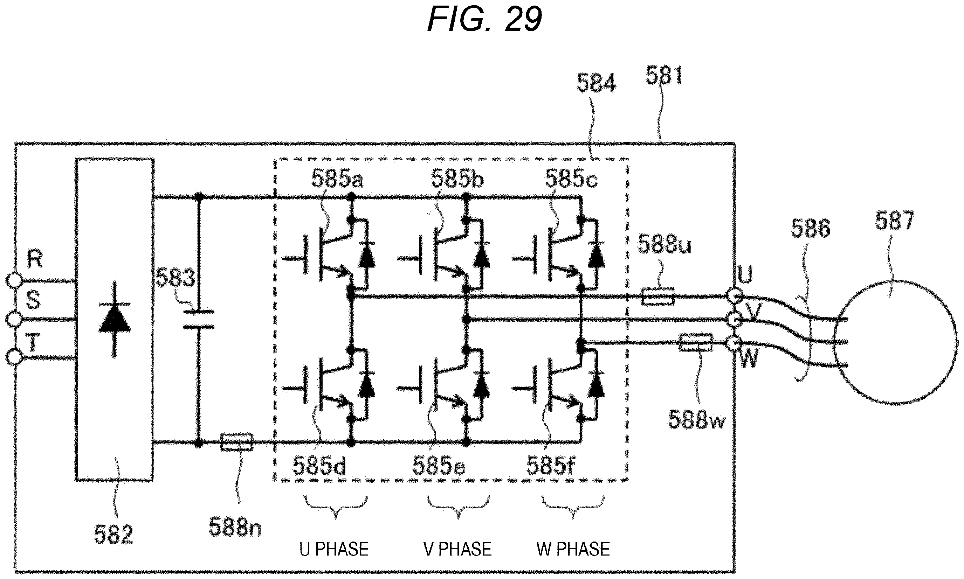

FIG. 29 illustrates a power conversion device of the related art, a motor, and cables connecting these components. A power conversion device 581 of the related art includes a forward converter circuit 582 which receives alternating current power to supply power to a motor, a capacitor 583, and a reverse converter circuit 584. The forward converter circuit 582 is configured by six diodes, and converts an alternating current power input from input terminals R, S, and T into direct current power. The capacitor 583 is connected to a direct current voltage line in the conversion device, and smoothens the voltage between lines. The reverse converter circuit 584 converts the direct current power to the alternating current power to drive the motor, and outputs the alternating current power to output terminals U, V, and W. The reverse converter circuit 584 includes semiconductor switches 585a to 585f, two switches are paired up to form a half-bridge circuit, and six switches form a three-phase (U, V, and W phases) bridge circuit. The switch elements of one phase are turned on alternately so as not to turn on the upper and lower switch elements at the same time. The outputs of the U, V, and W phases are connected to a motor 587 using three cables 586. The power conversion device 581 of the related art controls power to be supplied to the motor by PWM control in which the time of turning on each switch is changed on the basis of current information observed by current sensors 588u and 588w or a current sensor 588n.

In a case where the inside of the motor 587 or the cable 586 is short-circuited due to any of factors such as degradation or a physical damage of an insulating cover, an overcurrent is detected by the current sensor 588n or an overcurrent detection circuit (not illustrated) which is attached between the emitter and the collector of each switch to monitor a collector voltage to detect the overcurrent. In a case where the overcurrent is detected, all the switch elements are turned off to stop a conversion operation and the switch elements are prevented from being broken by heat energy generated by a large amount of current.

Citation List

Patent Literature

PTL 1: JP 10-23795 A

JP 2016 226243 A describes a power conversion apparatus comprising a plurality of switching elements that drives the motor that is connected by a cable, by performing ON/OFF control on the switching elements. The power conversion apparatus comprises: an inverse converter circuit that is formed from a plurality of switching elements of an upper arm and a plurality of switching elements of a lower arm for controlling a current of the motor; and a discrimination part which discriminates a location of short-circuit. When investigating the location of inter-phase short-circuit that occurs in the motor and the cable, the discrimination part generates a short-circuit current by simultaneously turning on the switching elements of the upper arm and the lower arm of different phases one by one and discriminates the location of short-circuit based on a current increase rate during short-circuit and a current decrease rate after short-circuit.

JP H06 66901 A describes a motor controller consisting of a motor for driving a control object for intermittent operation, an invertor for rotating and driving this motor, a convertor whose output voltage for supplying the invertor is variable, a means for detecting current allowed to flow in a direct current part of the invertor and a diagnostic control means having a diagnostic pattern of a motor circuit are provided, and a low voltage is applied in the motor circuit during operation stop of the control object and at this time the current allowed to flow in the direct current part of the invertor is diagnosed and judged on the basis of a diagnostic pattern.

Summary of Invention

Technical Problem

In a case where the operation of the power conversion device is stopped by the short circuit, the short circuit can be informed by notifying the information to a user. However, in a case where the operation of the power conversion device is stopped by a short circuit accident, the user is not able to specify a location where the short circuit occurs, that is, whether the short circuit accident occurs on the cable or in the motor. In particular, if it is known a short circuit location (for example, a distance from the power conversion device to a location where the short circuit occurs in meter units) on the cable, it is possible to specify the short circuit location on the line which is wired in a building or a facility and hard to be found out, and time and labor for restoration can be saved.

As a method of catching information of a short circuit location, PTL 1 introduces a method of estimating an abnormality by observing an inclination of current in which two switch elements are turned on in a short time after a short circuit occurs. In this case, since the inclination of current is determined by the inductance of a short circuit path, the estimation of the short circuit location is possible on the basis of the inductance.

However, it is not possible to determine a location on the cable where the short circuit occurs. In addition, in order to specify the short circuit location on the cable with high resolution, there is a need to provide a highspeed current measurement circuit to detect a small difference in the characteristics of the current waveform such as the inclination.

Solution to Problem

Accordingly, the present invention provides a power conversion device and a short circuit location determining method according to the independent claims 1 and 13.

Advantageous Effects of Invention

A power conversion device of the invention can determine whether a short circuit occurs in a cable connected to a power conversion device or in a motor using a low speed current sensor. Further, it is possible to specify an interphase short circuit location on the cable with high resolution using the low speed current sensor.

Brief Description of Drawings

[FIG. 1] FIG. 1 is a diagram illustrating a configuration of a first embodiment of a power conversion device of the invention.
[FIG. 2] FIG. 2 is a diagram illustrating a configuration of a switch driver circuit.
[FIG. 3] FIG. 3 is a diagram illustrating a relation between a path of the short circuit current flowing to inspect an interphase short circuit location and a state of a switch.
[FIG. 4] FIG. 4 is a diagram illustrating operation waveforms of the switch driver circuit to generate the
[FIG. 5] FIG. 5 is a flowchart of a short circuit location determination in the first embodiment of the invention.
[FIG. 6] FIG. 6 is a diagram illustrating changes in the switch state and a direct current voltage in the flow of the short circuit location determination of FIG. 5.
[FIG. 7] FIG. 7 is a flowchart of a short circuit situation inspection.
[FIG. 8] FIG. 8 is a flowchart of a short circuit current/short circuit time measurement.
[FIG. 9] FIG. 9 is a diagram illustrating an example of a short circuit current waveform in the short circuit current/short circuit time measurement of FIG. 8.
[FIG. 10] FIG. 10 is a flowchart of another method of the short circuit current/short circuit time measurement.
[FIG. 11] FIG. 11 is a diagram illustrating an example of the short circuit current waveform in the short circuit current/short circuit time measurement of FIG. 10.
[FIG. 12] FIG. 12 is a short circuit current waveform in a case where a direct current voltage Vdc is changed.
[FIG. 13] FIG. 13 is a flowchart of setting cable information which is stored in a cable information storage unit 123.
[FIG. 14] FIG. 14 is a diagram illustrating an example of a cross section of a three-phase motor cable.
[FIG. 15] FIG. 15 is a diagram illustrating a determination method used in a short circuit location determination unit 123 in a control circuit 105.
[FIG. 16] FIG. 16 is a diagram illustrating a configuration of a display device 108.
[FIG. 17] FIG. 17 is a table illustrating a correspondence relation between a display pattern and a short circuit location displayed in an LED segment 153.
[FIG. 18] FIG. 18 is a diagram illustrating a configuration of a transmitting device 109.
[FIG. 19] FIG. 19 is a diagram illustrating a configuration of the switch driver circuit of another protection circuit scheme.
[FIG. 20] FIG. 20 is a diagram illustrating a configuration of a second embodiment of the power conversion device of the invention.
[FIG. 21] FIG. 21 is a first flowchart illustrating the short circuit location determination in the second embodiment of the invention.
[FIG. 22] FIG. 22 is a diagram illustrating a change in direct current voltage in the flow of the short circuit location determination of FIG. 21.
[FIG. 23] FIG. 23 is a second flowchart of the short circuit location determination of the second embodiment in the invention.

[FIG. 24] FIG. 24 is a diagram illustrating a change in direct current voltage in the flow of short circuit location determination of FIG. 23.

[FIG. 25] FIG. 25 is a diagram illustrating an example that the invention is applied as an industrial inverter.

[FIG. 26] FIG. 26 is a diagram illustrating an example that the invention is applied to a railway vehicle.

[FIG. 27] FIG. 27 is a diagram illustrating an example that the invention is applied to a vehicle equipped with an electric motor.

[FIG. 28] FIG. 28 is a diagram illustrating an example of a tablet terminal which displays a determination result of the invention.

[FIG. 29] FIG. 29 is a diagram illustrating a power conversion device of the related art, a motor, and cables connecting these components.

Description of Embodiments

In the following, embodiments will be described using the drawings, but the invention is not limited to the embodiments described below.

First Embodiment

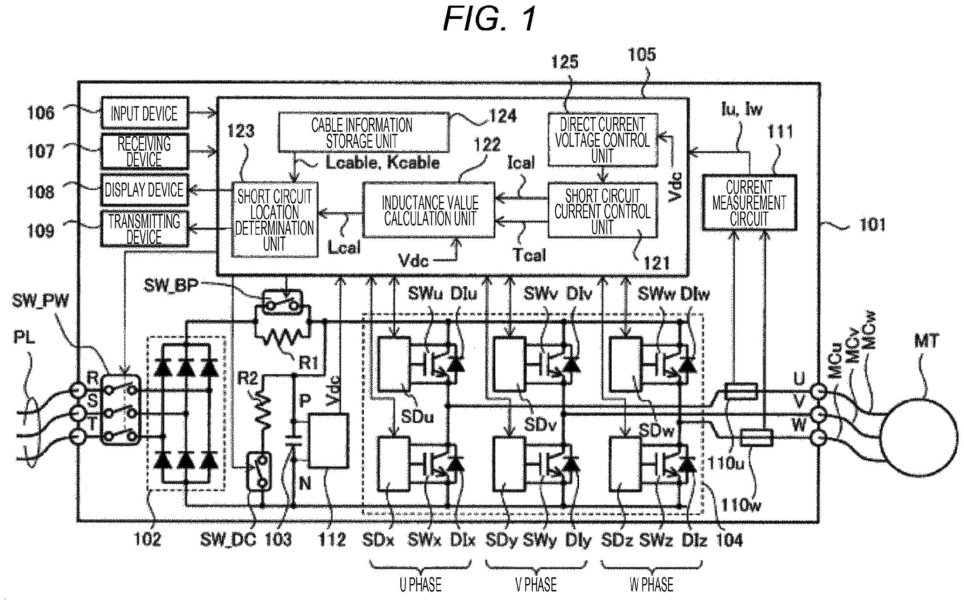

FIG. 1 illustrates a diagram illustrating a configuration of a first embodiment of a power conversion device of the invention. A power conversion device 101 includes a forward converter circuit 102 which receives alternating current power to supply power to a motor, a capacitor 103, and a reverse converter circuit 104. In addition, the power conversion device 101 includes a control circuit 105 to control the power conversion device 101, an input device 106 to manually input information to the control circuit 105, a receiving device 107 to receive information from an external system, a display device 108 to display output information from the control circuit 105, and a transmitting device 109 to transmit information to an external system.

The forward converter circuit 102 is configured by six diodes, converts alternating current power which is sent through power lines PL and input from input terminals R, S, and T into direct current power, and outputs the direct current power to the direct current power lines indicated with nodes P and N. With the rectification of the diodes of the forward converter circuit 102, a direct current voltage is generated in which a positive voltage appears in a direct current voltage line on a side of the node P and a negative voltage appears in a direct current voltage line on a side of the node N. The capacitor 103 is connected to the direct current voltage lines at the nodes P and N, and keeps (smoothens) the voltage between the lines even if a current changes steeply. The reverse converter circuit 104 converts the direct current power to the alternating current power to drive the motor, and outputs the alternating current power to output terminals U, V, and W.

A power source switch SW_PW is provided between the input terminals R, S, T and the forward converter circuit 102, and performs ON/OFF control of the alternating current power input. A resistor R1 and a bypass switch SW_BP are connected in parallel between the forward converter circuit 102 and the node P. The resistor R1 is a resistor for limiting an inrush current into the capacitor 103 which is generated at the time of turning on the power. The switch SW_BP bypasses the current by being turned on after limiting the inrush current. A resistor R2 and a discharge switch SW_DC are connected in series between the nodes P and N to be in parallel with the smoothing capacitor 103. When the switch SW_DC is turned on, a discharge current flows from the smoothing capacitor 103 through the resistor R2. Therefore, it is possible to suppress a voltage in a case where the direct current voltage between the nodes P and N is higher than a desired voltage. The above switches SW_PW, SW_BP, and SW_DC may be configured by semiconductor transistors or electromagnetic relays.

The reverse converter circuit 104 is configured by three half-bridge circuits of U, V, and W phases. The half-bridge circuit of the U phase is configured by an upper arm where a switch SWu and a diode DIu are connected in reverse parallel, and a lower arm where a switch SWx and a diode DIx are connected in reverse parallel. Similarly, the half-bridge circuit of the V phase is configured by a switch SWv, a diode DIv, a switch SWy, and a diode DIy. The half-bridge circuit of the W phase is configured by a switch SWw, a diode DIw, a switch SWz, and a diode DIz. In FIG. 1, IGBTs are used as switches, but MOSFETs may be used. In addition, normally silicon is employed for the semiconductor device, but SiC (silicon carbide) or GaN (gallium nitride) of a wide-gap semiconductor may be used to reduce loss. All of the switches SWu, SWv, SWw, SWx, SWy, and SWz are connected to switch driver circuits SDu, SDv, SDw, SDx, SDy, and SDz respectively. Each switch driver circuit is connected to electrodes of emitter, gate, and collector of each switch. The emitter, the gate, and the collector are names of the electrodes of an IGBT. In the case of MOSFET, the names correspond to a source, a gate, and a drain. In all of the switch driver circuits, there are built in a gate driver circuit which controls the gate voltage of the switch to turn the switch on or off, and an overcurrent protection circuit which detects an overcurrent flowing in the switch to block the switch at a high speed (turning off). The switch driver circuit includes a communication unit with respect to the control circuit 105. The communication unit is used to transfer an overcurrent detection signal from the switch driver circuit to the control circuit 105 when an ON/OFF control signal of a switch is transferred from the control circuit 105 to the switch driver circuit.

The power conversion device 101 includes two current sensors 110u and 110w to measure output current values of the respective phases between the reverse converter circuit 104 and the output terminals U and W, and a current measurement circuit 111 to measure these measurement values. The current sensors 110u and 110w measure the current values output from the output terminals U and W, and transfer these values as analog voltages or currents to the current measurement circuit 111. The current measurement circuit 111 samples and digitizes the analog information, and transmits the information as measurement current values Iu and Iw to the control circuit 105. In addition, the power conversion device 101 includes a voltage measurement circuit 112 which measures a voltage between the nodes P and N of the direct current voltage line (that is, both electrodes of the capacitor 103). The voltage measurement circuit 112 measures and digitizes the direct current voltage between the nodes P and N, and transmits the value as a direct current voltage value Vdc to the control circuit 105. The current measurement circuit 111 and the voltage measurement circuit 112 may be configured by a typical sampling circuit and an A/D conversion circuit.

The control circuit 105 includes a short circuit current control unit 121, an inductance value calculation unit 122, a short circuit location determination unit 123, a cable information storage unit 124, and a direct current voltage control unit 125 in order to determine a short circuit location on an output side (motor cables MCu, MCv, and MCw and a motor MT) of the power conversion device 101. The short circuit current control unit 121 controls the switches in the reverse converter circuit 104 at the time of inspecting a short circuit location on the basis of current value information from the current measurement circuit 111 and overcurrent detection information from all of the switch driver circuits SD in the reverse converter circuit 104 to control the short circuit current. In addition, the short circuit current control unit 121 transmits current value information Ical and time information Tcal obtained at the time of controlling the current to the inductance value calculation unit 122. The inductance value calculation unit 122 calculates an inductance value Lcal from Ical, Tcal, and the direct current voltage information Vdc, and sends the inductance value to the short circuit location determination unit 123. The short circuit location determination unit 123 estimates a short circuit location on the basis of the transmitted inductance value Lcal and the cable information stored in the cable information storage unit 124, and transmits the determination result to the display device 108 and the transmitting device 109. The direct current voltage control unit 125 drives the switches SW_PW, SW_BP, and SW_DC on the basis of the direct current voltage information Vdc, and transmits a trigger to the short circuit current control unit 121 to start the inspection on the short circuit location. Further, the control circuit 105 has a typical function of the PWM drive of the motor which is not related to the operation of the invention, and the description thereof will be omitted. In addition, elements which can be configured only by logic circuits may be realized in software using a microcomputer or a programmable logic.

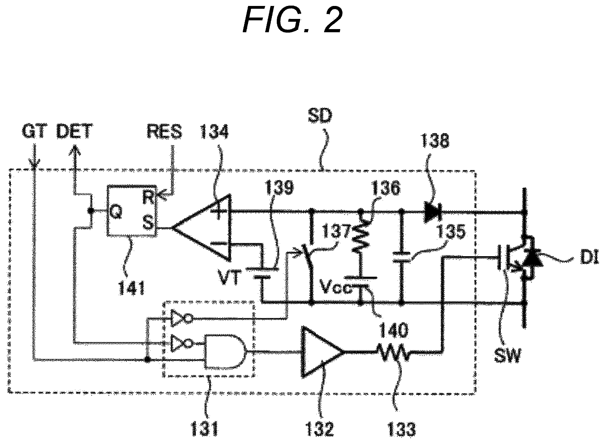

FIG. 2 illustrates a configuration of the switch driver circuits SDu, SDv, SDw, SDx, SDy, and SDz. The configurations of the switches are common. Therefore, in FIG. 2, suffixes u, v, w, x, y, and z of symbols SW, DI, and SD will be omitted. The switch driver circuit SD is configured by a logic circuit 131, a gate drive amplifier 132, a gate resistor 133, a comparator 134, a capacitor 135, a capacitor charging resistor 136, a capacitor discharging switch 137, a diode 138, constant voltage sources 139 and 140, and a latch circuit 141. The gate drive amplifier 132 and the gate resistor 133 are used to control turning ON/OFF of the switch SW to be connected. In a case where a gate signal GT from the control circuit 105 is "H", the gate drive amplifier 132 outputs a gate ON voltage to turn on the switch SW. In a case where the gate signal GT is "L", the gate drive amplifier 132 outputs a gate OFF voltage to turn off the switch SW. The gate resistor 133 controls a switching speed. On the other hand, the comparator 134, the capacitor 135, the capacitor charging resistor 136, the capacitor discharging switch 137, the diode 138, the constant voltage sources 139 and 140, and the latch circuit 141 form an overcurrent detection circuit. The overcurrent detection circuit is a circuit of a desaturation detection type. The constant voltage source 139 is a voltage source of an overcurrent threshold voltage VT. The constant voltage source 140 is a voltage source of a voltage Vcc higher than VT. The overcurrent threshold VT is a value determined from a voltage Vce between the collector and the emitter when the current flowing to the switch becomes an overcurrent threshold Iov at which the current is determined as the overcurrent. In an OFF state of the switch SW, the capacitor discharging switch 137 is turned on. Therefore, the output of the comparator is "L". In addition, in a case where no overcurrent occurs in an ON state of the switch SW, the voltage Vce of the switch SW (IGBT) is sufficiently low, and the capacitor 135 is discharged through the diode 138. Therefore, the output of the comparator is "L". By the way, in a case where the overcurrent occurs in the ON state of the switch SW, the voltage of the collector of the switch SW (IGBT) becomes higher than the threshold voltage VT, and the capacitor 135 is not discharge. If the capacitor 135 is discharged by the charging current of the capacitor charging resistor 136 and the potential of the capacitor exceeds the threshold voltage VT, the comparator 134 outputs "H". Then, the output Q of the latch circuit becomes "H", the gate signal GT is invalidated by the logic circuit 131, the switch is forcibly blocked, and the driver circuit SD enters a state where an overcurrent protection function operates. In addition, the overcurrent detection is transferred as an overcurrent detection signal DET to the control circuit 105. The overcurrent protection function is released when a reset signal from the control circuit 105 is input to RES to reset the latch circuit 141. As described above, the switch driver circuit illustrated in FIG.

2 serves as a gate driver circuit equipped with the overcurrent protection function, and can transfer the overcurrent detection to the control circuit 105 immediately after the overcurrent detection caused by a short circuit. Further, the capacitor charging resistor 136 is provided to prevent an error operation caused by noises, and generates a delay in the overcurrent detection time. In a case where the delay time is in such a degree that cannot be ignored, the delay time can be derived in an overcurrent detection time measurement operation described below and can be corrected.

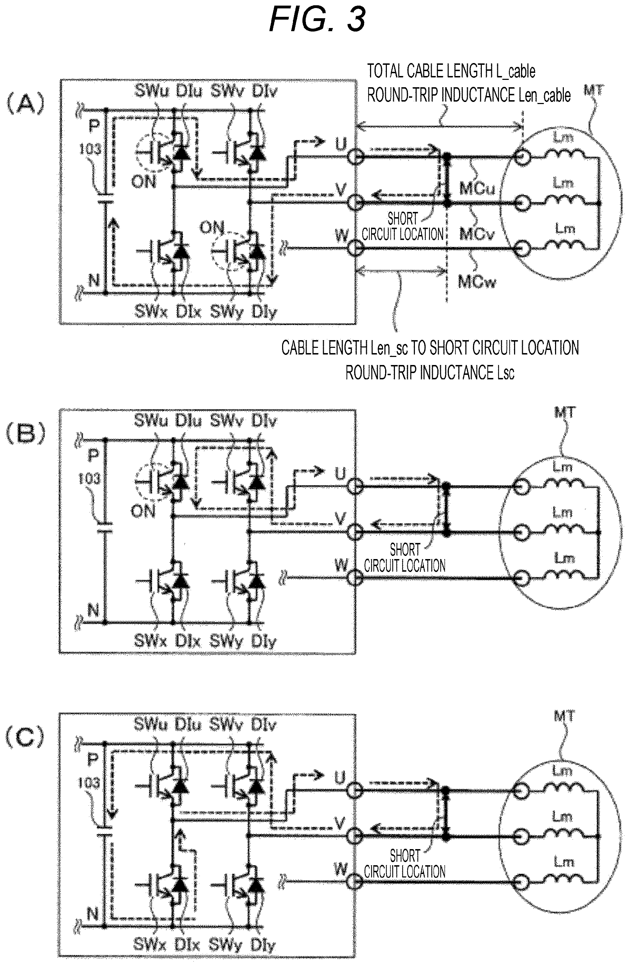

FIG. 3 illustrates a relation between a path of the short circuit current flowing to inspect an interphase short circuit location in the invention and a state of the switch. FIG. 3(A) illustrates the short circuit current path and the switch state when the short circuit current is increased, FIG. 3(B) when the short circuit current is kept, and FIG. 3(C) when the short circuit current is reduced. FIG. 3 illustrates an example that a short circuit occurs between the motor cables MCu and MCv (that is, between the phases U and V).

As illustrated in FIG. 3(A), when the short circuit current is increased, the upper arm and the lower arm of two phases where the interphase short circuit occurs are turned on one by one, and causes the current to flow to the short circuit location through a broken line using the direct current voltage Vdc applied to both electrodes of the capacitor 103 as an electromotive force. A current I at this time is illustrated in Table 1, and is increased compared to time t.

$$I = Vdc \cdot t / Lsc \quad \text{(Equation 1)}$$

Herein, t is a time since both the switches SWu and SWy are turned on, and Lsc is an inductance of the motor cable from the power conversion device 101 up to the short circuit location. Further, the inductance of the current path in the power conversion device is ignored. Modifying Equation 1, Lsc is expressed as follows.

$$Lsc = Vdc \cdot (I/t) \quad \text{(Equation 2)}$$

Therefore, the inductance Lsc can be calculated by obtaining (I/t) while keeping the state of FIG. 3(A) until the current I and time t can be measured. Since a cable length Len_sc and the inductance Lsc from the power conversion device 101 and the short circuit location are proportional, a conversion coefficient is inspected separately, so that the cable length Len_sc from the value of the inductance Lsc to the short circuit location can be estimated. Further, the switches SWu and SWy are turned on in FIG. 3(A). However, even in a case where the switches SWv and SWx are turned on, the inductance Lsc can be calculated only by setting the current of the motor cable in a reverse direction.

As illustrated in FIG. 3(A), if the switch SWy is turned off after the short circuit current is increased, the current keeps continuously flowing on a loop depicted with a broken line in FIG. 3(B). The current at this time is expressed in Equation 3, and reduced in proportion to time.

$$I = Ib - Vf \cdot tb / Lsc \quad \text{(Equation 3)}$$

Herein, Ib is a current value when the switch SWy is turned off, Vf is a forward drop voltage of the freewheel diode DIv, and tb is time taken after the switch SWy is turned off. Since Vf is smaller than Vdc by 1 to 3 digits in general, the current reducing speed in FIG. 3(B) becomes delayed by about 1 to 3 digits compared to the current increasing speed of FIG. 3(A). Therefore, in a condition that Lsc is relatively large, the current can be considered as almost constant. Therefore, a current value at the moment when the switch SWy is turned off can be measured by a current sensor of which measurement speed is relatively slow after the switch SWy is turned off. Further, SWy is turned off in FIG. 3(B). However, even in a case where the switch SWu is turned off, the similar current can be kept.

After FIG. 3(A) or FIG. 3(B), if all the switches are turned off, the current illustrated in FIG. 3(C) flows on a loop depicted with a broken line. The current at this time is reduced in proportion to time, and reduced as Equation 4 until the current becomes 0.

$$I = Ic - Vdc \cdot tc / Lsc \quad \text{(Equation 4)}$$

Herein, Iu1 is a current value when all the switches are turned off, and tc is time taken after all the switches are turned off.

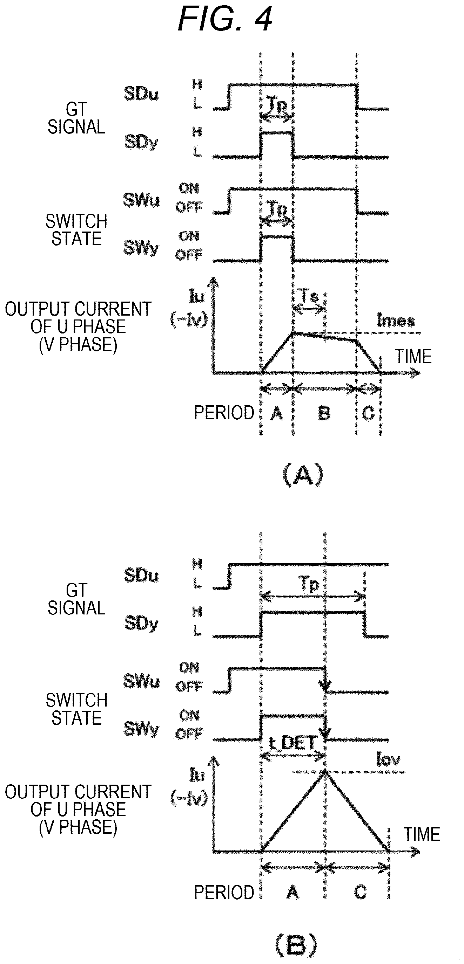

FIG. 4 illustrates operation waveforms of the switch driver circuits SDu and SDy to generate the short circuit current illustrated in FIG. 3. FIGS. 4(A) and 4(B) illustrate waveforms in a case where the short circuit current between U and V phases is inspected.

FIG. 4(A) illustrates the operation waveform in a case where a round-trip inductance Lsc up to the short circuit location is relatively large. The control circuit 105 supplies a pulse in the GT signals of the driver circuits SDu and SDy such that both circuits are turned on during a period Tp. With this configuration, the switches SWu and SWy are turned on according to the GT signal. In a period A when both the switches SWu and SWy are turned on, the short circuit current flows in the path illustrated in FIG. 3(A). In a period B when one switch is turned off thereafter, the short circuit current flows in the path illustrated in FIG. 3(B). Then, in a period C when all the switches are turned off thereafter, the short circuit current illustrated in FIG. 3(C) flows. In the period B in a series of operations where the short circuit occurs, the increase/decrease of the current value becomes relatively less. Therefore, if the current is measured at time Ts near the start point of the period B, it is possible to perform the measurement using the current sensor of which the measurement speed is relatively slow. Then, the round-trip inductance Lsc up to the short circuit location can be obtained by substituting time Tp to t of the equation (Equation 1), and a current value Imes measured by the current measurement circuit 111 to I.

Further, the current value Imes is obtained by reading the measurement value Iu of the current sensor 110u in the case of the short circuit between the U-V phases, the measurement value Iw of the current sensor 110w in the case of the short circuit between the V-W phases, and any one of the measurement value Iu and Iw in the case of the short circuit between the W-U phases. Alternatively, the current value Imes may be obtained by selecting and reading Max (Iu, Iw) indicating a larger one of the measurement values Iu and Iw. Even in the following explanation on the current value Imes, the reading of the measurement value from the current sensor is performed similarly, and the description will be omitted.

FIG. 4(B) illustrates the operation waveform in a case where the round-trip inductance Lsc up to the short circuit location is relatively small. Similarly to the case of FIG. 4(A), the control circuit 105 supplies a pulse to the GT signals of the driver circuits SDu and SDy such that both circuits are turned on during the period Tp (the scales of time axis of FIGS. 4(A) and 4(B) are different). The short circuit current exceeds the overcurrent threshold Iov before the switch is turned off again by the GT signal, the overcurrent protection circuit in the driver circuits SDu and SDy operates, and both or any one of the switches SWu and SWy is turned off regardless of the GT signal (FIG. 4(B) illustrates a case where both switches are turned off). In a period A when both the switches SWu and SWy are turned on, the short circuit current flows in the path illustrated in FIG. 3(A). Thereafter, the short circuit current illustrated in FIG. 3(C) flows in the period C when all the switches are turned off. In this case, time t up to the overcurrent detection after a signal to turn on both switches is supplied to the GT signals of two switches is substituted to t of the equation (Equation 1), and the overcurrent threshold Iov is substituted to I, so that the inductance Ls can be obtained.

In the operation of FIG. 4(A), the current reduction in the period B is necessary in order to measure the stable current value Imes in a period Ts, and thus the condition of a relatively large inductance Lsc is required as can be seen from (Equation 3). Therefore, time Tp when both switches are turned on is derived using (Equation 1) from the inductance value Lsc which is required for the measurement in the operation of FIG. 4(A). The derived value is set in advance as a mode switching time Tmc. In a case where the short circuit is detected in a time shorter than the mode switching time Tmc, the measurement is performed in the operation of FIG. 4(B) and, if not, the measurement is performed in the operation of FIG. 4(A).

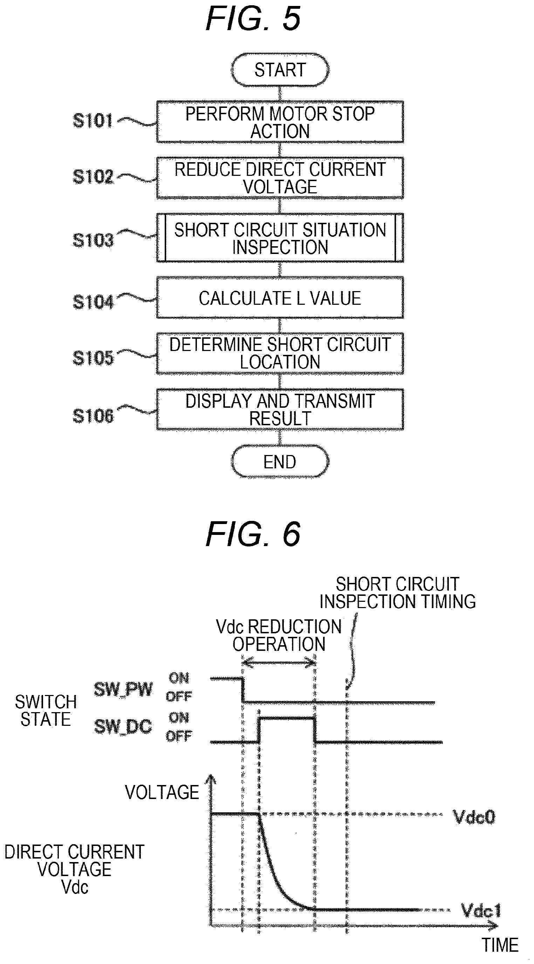

FIG. 5 illustrates a flowchart of a short circuit location determination in the first embodiment of the invention. The flow of FIG. 5 is started by an overcurrent detection signal from the protection circuit as the short circuit occurs, and a trigger from the input device 106 or the receiving device 107. After starting, the control circuit 105 performs a motor stop action (S101). Specifically, the power supplying to the motor is stopped by turning off all the switches of the forward converter circuit 102, and this state is kept until the current values of all the phases measured by the current measurement circuit 111 become 0. After the motor is stopped, the control circuit 105 controls the switches SW_PW and SW_DC to reduce the direct current voltage Vdc (S102). In a state where the direct current voltage is reduced, the short circuit current control unit 121 performs the inspection on the short circuit situation. In a case where short circuit information is successfully acquired, the current value information Ical and the time information Tcal are provided to the inductance value calculation unit 122 (S103). The inductance value calculation unit 122 calculates the inductance value Lcal from Ical, Tcal, and the direct current voltage information Vdc, and sends the calculated value to the short circuit location determination unit 123 (S104) The short circuit location determination unit 123 estimates the short circuit location on the basis of the transmitted inductance value Lcal and the cable information stored in the cable information storage unit 124 (S105). The determination result is transmitted to the display device 108 and the transmitting device 109 (S106).

FIG. 6 illustrates changes in the switch state and the direct current voltage (Vdc) in the flow of the short circuit location determination of FIG. 5. At the time of driving the motor, the control circuit 105 turns on the power source switch SW_PW and the bypass switch SW_BP and turns off the discharge switch SW_DC to supply power to the motor. The direct current voltage becomes a voltage Vdc0 by the forward converter circuit 102. After the motor stop action, if the control circuit 105 turns off the power source switch SW_PW, and turns on the discharge switch, the discharging of the smoothing capacitor 103 is started, and the direct current voltage is reduced. If it is detected that the direct current voltage value Vdc measured by the voltage measurement circuit 112 is lowered down to a predetermined voltage Vdc1, the control circuit 105 turns off the discharge switch. In this state, the capacitor 103 holds that the direct current voltage is Vdc1. Thereafter, a short circuit situation inspection (S103) is performed. Further, the bypass switch SW_BP is always in an ON state during the operation of FIG. 6.

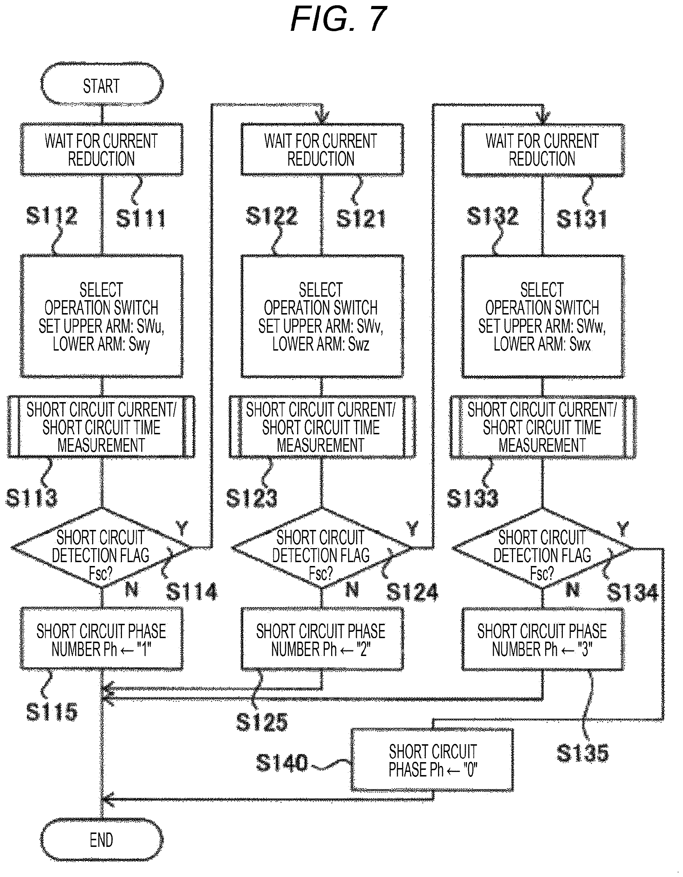

FIG. 7 illustrates a flowchart of the short circuit situation inspection (S103). The flowchart of FIG. 7 are configured by three flowcharts at large, which are flowcharts of the short circuit situation inspection between U-V phases, V-W phases, and W-U phases. First, in the short circuit situation inspection between U-V phases, the control circuit 105 performs a current reduction standby in the beginning, and is on standby until the currents Iu and Iw measured by the current measurement circuit 111 become 0 (S111). Next, the control circuit 105 sets two switches to SWu and SWy to inspect the short circuit current between the U-V phases (S112). Thereafter, the control circuit 105 performs a short circuit current/short circuit time measurement, and acquires a short circuit detection flag Fsc which indicates information whether the short circuit is detected. Further, in a case where the short circuit is detected, the current value information Ical and the time information Tcal are also acquired (S113). In a case where the short circuit detection flag Fsc = "Y", a numerical value "1" indicating the short circuit between the U-V phases is substituted to a short circuit phase number variable Ph (S114, S115). In a case where the short circuit detection flag Fsc = "N", the process proceeds to the flowchart for short circuit investigation on the V-W phases. Similarly, the short circuit inspection on the V-W phases is performed. If the short circuit is detected, a numerical value "2" indicating the short circuit between the V-W phases is substituted (S121 to S125). Further, if there is no short circuit, the process proceeds to the flowchart for short circuit investigation on the V-U phases. Similarly, the short circuit inspection on the W-U phases is performed. If the short circuit is detected, a numerical value "3" indicating the short circuit between the V-W phases is substituted, and the process ends (S131 to S135). In a case where the short circuit is not detected, a numerical value "0" is substituted to the variable Ph indicating that a short circuit phase is unknown (S140).

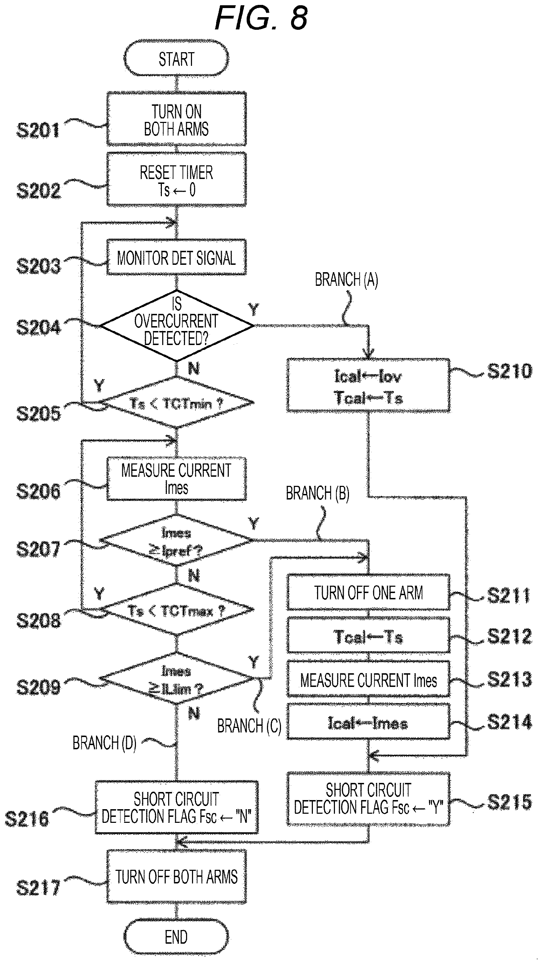

FIG. 8 illustrates a flowchart of the short circuit current/short circuit time measurement (S113, S123, S133). First, the control circuit 105 outputs a command to turn on two switches which are set in advance to the corresponding switch driver circuit SD (S201). At the same time, a timer variable Ts is reset to 0 (S202). The timer variable Ts is a variable which increases with time, and may be configured by a counter which counts up using inner clocks in the control circuit 105. During a period when the timer variable Ts is smaller than the mode switching time Tmc, the overcurrent detection signals DET from all of the switch driver circuits SD are monitored to handle the current increase of a short time in a case where the round-trip inductance Lsc of the short circuit current path is small (S203 to S205). In a case where the signal DET is received from any switch driver circuit SD, the process proceeds to a branch (A). After the timer variable Ts becomes larger than the mode switching time Tmc, the current measurement of the current measurement circuit 111 is repeatedly performed until the timer variable Ts reaches a measurement end time Tfin (S206 to S208). In a case where the current value Imes measured by the current measurement circuit 111 exceeds a measurement preferable value Ipref, the process proceeds to a branch (B). After the timer variable Ts exceeds the measurement end time Tfin, the last measured current value Imes and a short circuit current detection lower limit ILlim are compared (S209). If Imes ≥ ILlim is satisfied, the process proceeds to a branch (C). If not, the process proceeds to a branch (D).

In a case where the process proceeds to the branch (A), the overcurrent threshold Iov is substituted to Ical, and time Ts of the timer variable is substituted to Tcal (S210).

Herein, the measurement preferable value Ipref means a current value suitable for the measurement of the current sensors 110u and 110w, and is a current value which has a sufficient resolution and a margin in the measurement upper lime.

In a case where the process proceeds to the branches (B) and (C), any one of the upper arm or the lower arm of the turned-on switches is turned off, and the value of the timer variable Ts at the same timing is substituted to Tcal (S211, S212). Thereafter, the current measurement is performed by the current measurement circuit 111, and the measurement value Imes is substituted to Ical (S213, S214).

In a case where the process proceeds to the branches (A), (B), and (C), "Y" is substituted to the short circuit detection flag Fsc (S215). On the other hand, in a case where the process proceeds to the branch (D), "N" is substituted to the short circuit detection flag Fsc (S216). In any branch, a command to turn off the switch is output to all the switch driver circuits SD at the end of the process, and the process ends (S217).

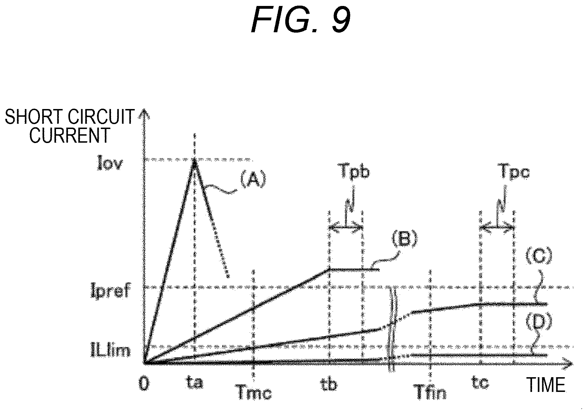

FIG. 9 illustrates an example of a short circuit current waveform in the short circuit current/short circuit time measurement of FIG. 8. In a case where the round-trip inductance Lsc of the short circuit current path is minimized, the process passing the branch (A) is performed in the flowchart of FIG. 8. The current waveform in this case becomes the waveform (A). The current is blocked by the overcurrent protection function of the switch driver circuit SD at the time point when the short circuit current is steeply increased and reaches the overcurrent threshold Iov. The short circuit current is steeply reduced. In this case, the inductance Ls can be obtained by substituting time ta and the value of Iov to t and I of (Equation 2). Next, in a case where the inductance Lsc is increased still more, the process passing the branch (B) is performed in the flowchart of FIG. 8. The current waveform in this case becomes the waveform (B). The current becomes almost constant by turning off one switch at time tb after the current value exceeds the measurement preferable value IPref. The round-trip inductance Lsc of the short circuit current path can be obtained by substituting the value of time tb and the current value Imes measured to I and t of (Equation 2) at timing (for example, a period Tpb) after time tb. Further, in a case where the round-trip inductance Lsc is increased still more, the process passing the branch (C) is performed in the flowchart of FIG. 8. The current waveform in this case becomes the waveform (C). The current becomes almost constant by turning off one switch at time tc after the measurement end time tfin. The inductance Ls of the short circuit path can be obtained by substituting the current value Imes measured at timing (for example, the period Tc) after time tc and the value of time tc to I and t of (Equation 2). Further, in a case where the round-trip inductance Lsc is larger, the process passing the branch (D) is performed in the flowchart of FIG. 8. The current waveform in this case becomes the waveform (D). Since the current does not exceed ILlim at the measurement end time tfin, it is determined that an inductance (Lm) through the motor MC is observed. It is determined that the short circuit does not occur between the phases under inspection.

Through the operations according to the flowcharts of FIGS. 7 and 8 described above, the round-trip inductance Lsc of the short circuit path can be measured by measuring the short circuit current of FIG. 9 and time related thereto.

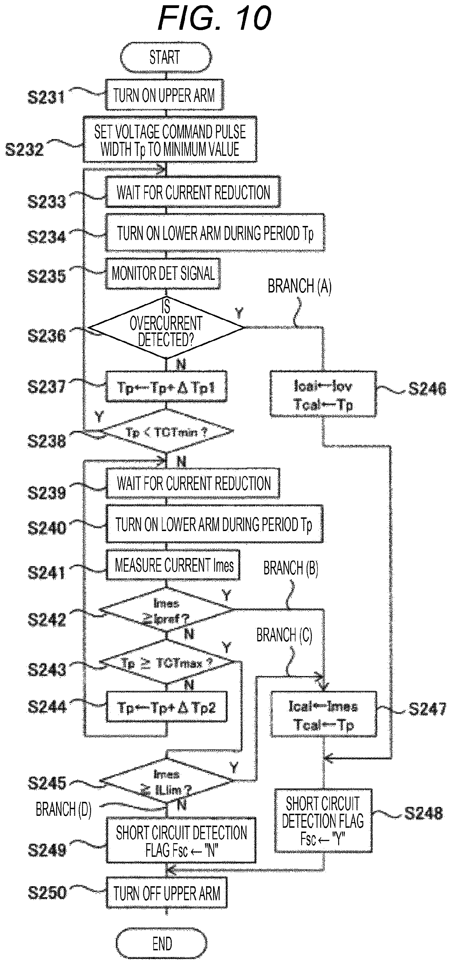

FIG. 10 illustrates a flowchart of another method of the short circuit current/short circuit time measurement (S113, S123, S133). First, the control circuit 105 outputs a command to turn on only the switch of the upper arm of two switches set in advance to the corresponding switch driver circuit SD (S231). In addition, the value of a minimum pulse width Ta1 is set as an initial value to the variable Tp to determine a voltage command pulse width (S232). Next, it is inspected a pulse width in which an overcurrent is detected while the pulse width of turning on the switch of the lower arm is widened (S233 to S238). The control circuit 105 performs the current reduction standby, and is on standby until the currents Iu and Iw measured by the current measurement circuit 111 becomes 0 (S233). After the current becomes 0, the control circuit 105 outputs a command to turn on the lower arm by a time width of the value of the variable Tp to the corresponding switch driver circuit SD (S234). Thereafter, in a case where the overcurrent detection signal DET is input from the switch driver circuit SD, and the overcurrent is detected, the process proceeds to the branch (A) (S235, S236). If not, the variable Tp is increased by ΔTp1, and the process of S233 to S236 is repeatedly performed until the variable Tp exceeds the mode switching time Tmc (S237, S238).

After the variable Tp exceeds the mode switching time Tmc, it is inspected a pulse width in which the current value Imes exceeds the measurement preferable value Ipref while the pulse width of turning on the switch of the lower arm is widened (S239 to S244). The control circuit 105 performs the current reduction standby, and is on standby until the current Iu and Iw measured by the current measurement circuit 111 becomes 0 (S239). After the current becomes 0, the control circuit 105 outputs a command to turn on the lower arm by a time width of the value of the variable Tp to the corresponding switch driver circuit SD (S240). Thereafter, the current measurement is performed by the current measurement circuit 111 (S241). In a case where the measured current value Imes is larger than the current preferable value Ipref, the process proceeds to the branch (B) (S241, S242). If not, the variable Tp is increased by ΔTp2, and the process of S239 to S242 is repeatedly performed until the variable Tp exceeds the value of the measurement end time Tfin (S243, S244) .

After the variable Tp exceeds the measurement end time Tfin, the last measured current value Imes and the short circuit current detection lower limit ILlim are compared. If Imes ≥ ILlim, the process proceeds to the branch (C) and, if not, the proceeds to the branch (D) (S245).

In a case where the process proceeds to the branch (A), the overcurrent threshold Iov is substituted to Ical, and the value of the pulse width variable Tp is substituted to Tcal (S246).

In a case where the process proceeds to the branches (B) and (C), the last measured current value Imes is substituted to Ical, and the value of the pulse width variable Tp is substituted to Tcal (S247). In a case where the process proceeds to the branches (A), (B), and (C), "Y" is substituted to the short circuit detection flag Fsc (S248). On the other hand, in a case where the process proceeds to the branch (D), "N" is substituted to the short circuit detection flag Fsc (S249). In any branch, a command to turn off the switch of the upper arm is output to the corresponding SD drive circuit at the end of the process, and the process ends (S250).

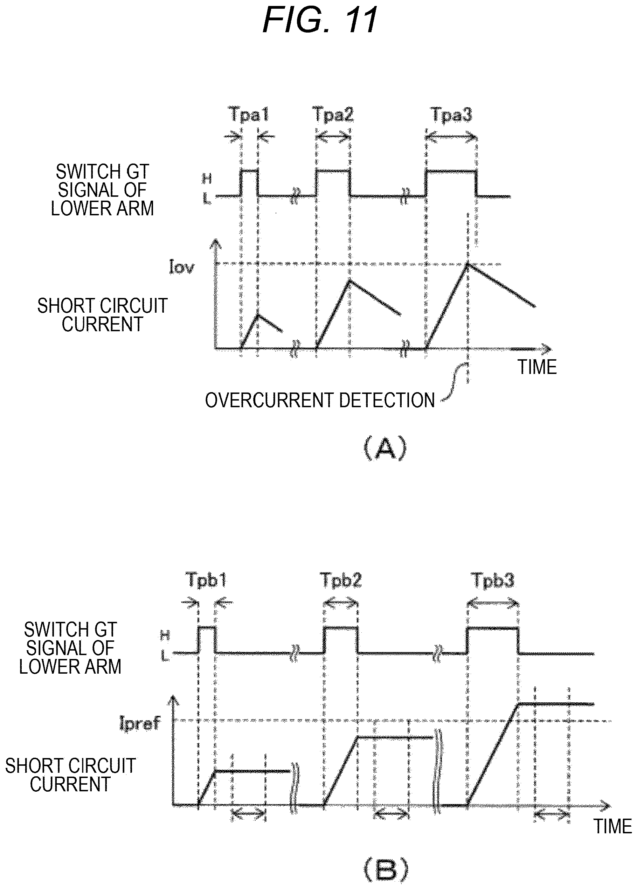

FIG. 11 illustrates an example of the short circuit current waveform in the short circuit current/short circuit time measurement of FIG. 10. FIG. 11(A) illustrates an example of the GT signal of the lower arm and the short circuit current waveform in a loop of the overcurrent detection inspection (S233 to S238) of the flowchart of FIG. 10. The control circuit 105 outputs one pulse to the GT signal every cycle of the loop, and gradually widens the pulse width to Tpa1, Tpa2, and Tpa3 in this order. In a certain pulse width (Tpa3 in the example of the drawing), in a case where the short circuit current exceeds an overcurrent threshold value, the inspection on the short circuit current ends at that time point. The round-trip inductance Lsc of the short circuit current path can be obtained by substituting the pulse width Tp and the value of Iov when the short circuit is detected to t and I of (Equation 2). Strictly speaking, an error may occur in the pulse width increase ΔTp1, but can be ignored if ΔTp1 is small.

FIG. 11(B) illustrates an example of the GT signal of the lower arm and the short circuit current waveform in a loop of the overcurrent detection inspection (S239 to S244) of the flowchart of FIG. 10. The control circuit 105 outputs one pulse to the GT signal every cycle of the loop, and gradually widens the pulse width to Tpb1, Tpb2, and Tpb3 in this order. In addition, the current measurement value Imes from the current measurement circuit 111 is acquired at every time in the periods Tpm1, Tpm2, and Tpm3 after each pulse. In a certain pulse width (Tpb3 in the example of the drawing), in a case where the current measurement value Imes exceeds the measurement preferable value Ipref, the inspection on the short circuit current ends at that time point. The round-trip inductance Ls of the short circuit path can be obtained by substituting the last measured current value Imes and the value of the pulse width Tp at that time to I and t of (Equation 2).

In a case where the pulse width exceeds the measurement end time tfin, the inspection ends even if the current value Imes does not reach the measurement preferable value IPref. The round-trip inductance Lsc can be obtained by (Equation 2) as described above. However, in a case where Imes does not exceed ILlim, it is determined that the inductance (Lm) passing through the motor MC is observed, and it is not determined that the short circuit does not occur between the phases under inspection.

Through the operations according to the flowcharts of FIGS. 7 and 10 described above, the round-trip inductance Lsc of the short circuit path can be obtained by measuring the short circuit current of FIG. 11 and time related thereto.

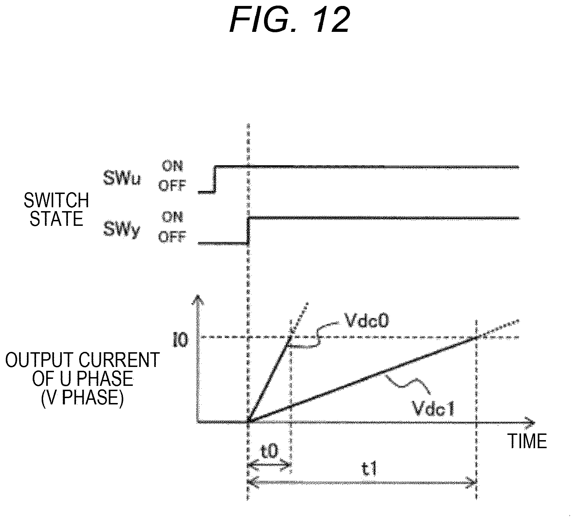

FIG. 12 illustrates the short circuit current waveform in a case where the direct current voltage Vdc is changed. Two waveforms A and B illustrated in FIG. 12 represent the short circuit currents which are generated by turning on two switches illustrated in the period A of FIG. 4. The waveform A is generated on the condition of the direct current voltage Vdc = Vdc0, and the waveform B is generated on the condition of the direct current voltage Vdc = Vdc1, in which the condition of the direct current voltage Vdc is different (Vdc1 < Vdc0). Since these current waveforms follow (Equation 1), a time required to increase the current value from 0 to a predetermined current value 10 is increased in inverse proportion to Vdc (the relation of Vdc0:Vdc1 = t1:t0 in the waveform of the drawing). Therefore, it is possible to obtain the following merit on the operation of the short circuit current/short circuit time measurement by reducing the direct current voltage Vdc.

(Merit) The time resolution can be improved without improving time measurement accuracy in the operation of the short circuit current/short circuit time measurement illustrated in FIGS. 8 and 9. As a result, the accuracy of the round-trip inductance Lsc of the short circuit path is improved. In addition, the time resolution can be improved without improving the accuracy of the pulse width control in the operation of the short circuit current/short circuit time measurement illustrated in FIGS. 10 and 11. As a result, the accuracy of the round-trip inductance Lsc of the short circuit path is improved.

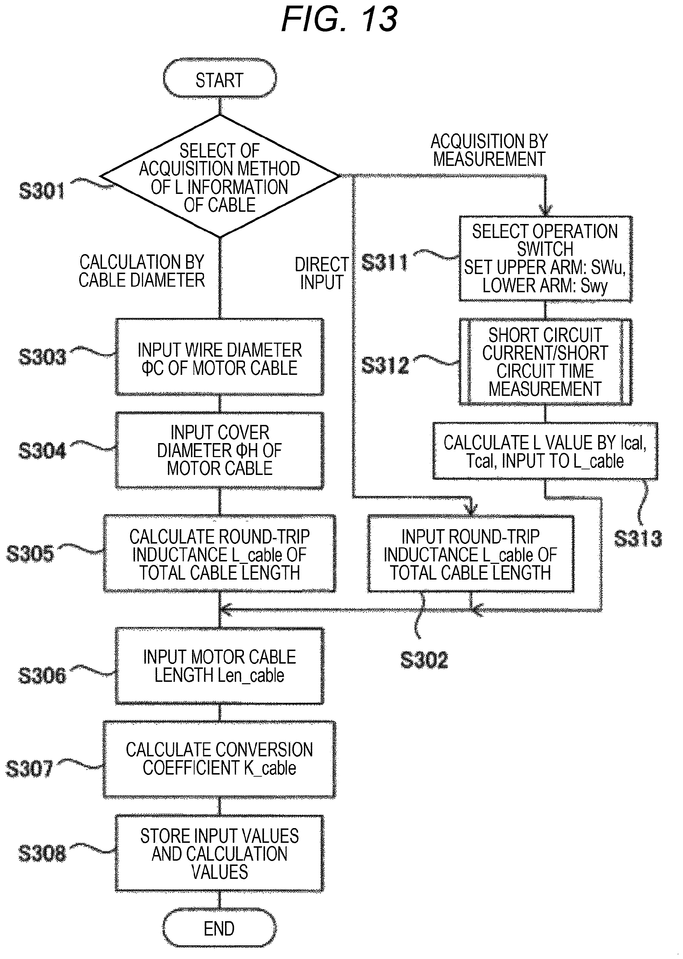

FIG. 13 illustrates a flowchart of setting the cable information which is stored in the cable information storage unit 124. This flowchart is performed at least one time before the short circuit location determination operation. First, a user is urged to select a method of acquiring the inductance value (L value) information of the cable. There are three options, (1) Direct input, (2) Calculation from cable diameter, and (3) Acquisition from measurement. In a case where (1) Direct input is selected, the round-trip inductance of the total length of the cable is directly input through the input device 106 and the receiving device 107 (S302). The round-trip inductance value of the total cable length may be acquired separately by a LCR meter before the motor cables are installed for example. In a case where (2) Calculation from cable diameter is selected, a wire diameter $\varphi$C of the motor cable and a cover diameter $\varphi$H of the cable are input through the input device 106 and the receiving device 107 (S303, S304). The control circuit 105 calculates a round-trip inductance L_cable of the total cable length from the wire diameter $\varphi$C and the cover diameter $\varphi$H (S305). In a case where (3) Acquisition from measurement is selected, the round-trip inductance L_cable of the cable total length is measured by the same operation of the flowchart of FIG. 7. In this case, the measurement is needed before a short circuit occurs. Further, there is a need to perform a short circuit test on the opposite side of the power conversion device of the motor cable. In this measurement, the control circuit 105 sets two switches SWu and SWy to be operated for the inspection on the short circuit current between the U-V phases (S311). Thereafter, the control circuit 105 performs the short circuit current/short circuit time measurement (S312). The short circuit current/time measurement can be performed according to the flowchart of FIG. 8 or 10.

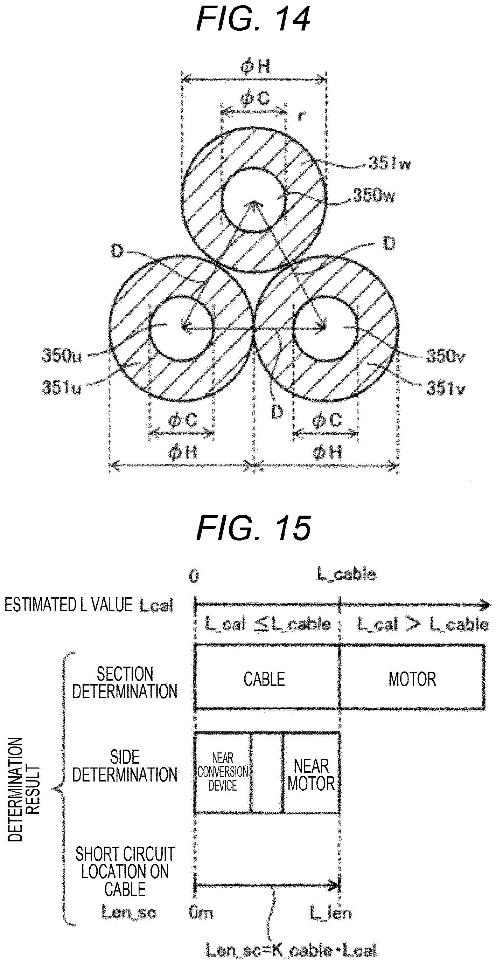

After acquiring the round-trip inductance of the total cable length, a motor cable length Len_cable is input through the input device 106 and the receiving device 107 (S306). A conversion coefficient K_cable for the conversion of the inductance and the length of the cable is calculated from K_cable = L_cable/Len_cable (S307). The above input values and measurement values are stored in the cable information storage unit 124, and the process ends (S308). FIG. 14 illustrates an example of a cross section of a three-phase motor cable. The cables illustrated in the drawing are configured by three cables 351u, 351v, and 351w which have wires 350u, 350v, and 350w of a diameter $\varphi$C and covers of a diameter $\varphi$H.

On the other hand, it can be seen that the round-trip inductance of two parallel cables can be calculated by Equation 5.

$$K = 0.05 + 0.46052 \cdot \log(D/r) \, [\text{mH/km}] \quad (\text{Equation 5})$$

Herein, K represents an inductance per unit length, D represents a distance between cables, and r represents a radius of the wire. Therefore, in a case where three cables are densely combined, the distance D between cables is $2 \cdot \varphi$H, the conversion coefficient can be obtained from the radius r = $\varphi$C/2 of the wire, so that the conversion coefficient K_cable (= K) can be calculated from the wire diameter $\varphi$C of the cable and the cover diameter $\varphi$H.

FIG. 15 illustrates a determination method used in the short circuit location determination unit 123 in the control circuit 105. The short circuit location determination unit 123 performs a section determination and a side determination illustrated in the drawing on the basis of the inductance value Lcal transmitted from the inductance value calculation unit 122 and the inductance value L_cable transmitted from the cable information storage unit 124, and the conversion coefficient K_cable. In the section determination, in the case of $L\_cal \leq L\_cable$, the short circuit location is determined as on the cable, in the case of $L\_cal > L\_cable$, the short circuit location is determined as on the motor. In addition, in the side determination, in the case of $L\_cal \leq L\_cable$, and in a case where Lcal is near 0, it is determined that the short circuit location on the cable is near the power conversion device, and in a case where Lcal is near L_cable, it is determined that the short circuit location on the cable is near the motor. Further, a short circuit location Len_sc on the cable is determined by $Len\_sc = K\_cable \cdot L\_cal$.

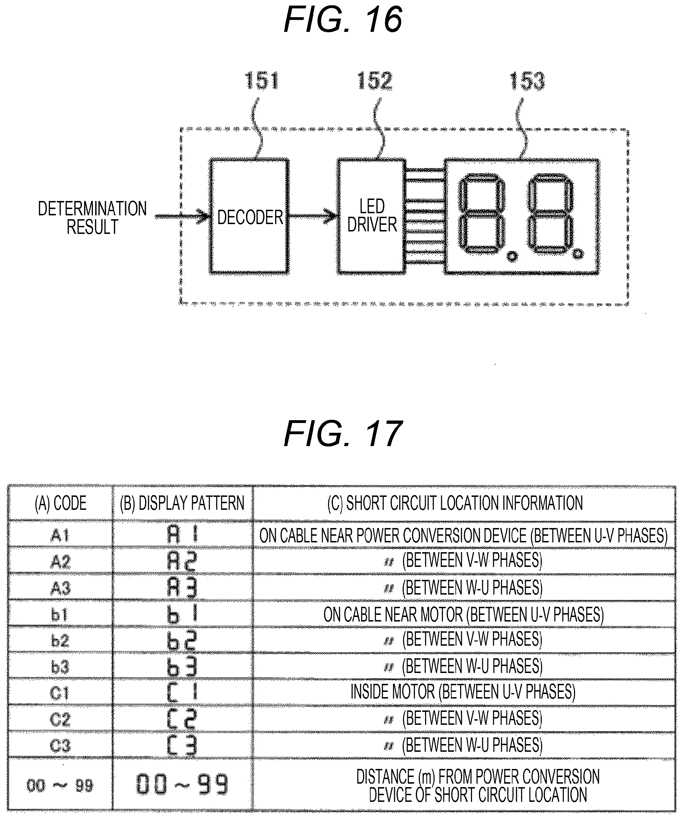

FIG. 16 illustrates a diagram illustrating a configuration of the display device 108. The display device 108 is configured by a decoder 151, an LED driver 152, and an LED segment 153 which is a two-digit display. The short circuit location determination result sent from the control circuit 105 and the short circuit phase number Ph are decoded to a display pattern of numbers and characters of the LED segment by the decoder 151. The LED 152 driver displays the decoded display pattern to the LED segment 153 using a current signal.

FIG. 17 is a table illustrating a correspondence relation between the display pattern and the short circuit location displayed in the LED segment 153. The display pattern of (B) is a pattern obtained by expressing the code of (A) using a 7-segment LED. Codes A1 to A3 represent that the short circuit location is near the power conversion device of the motor cable, codes b1 to b3 represent that the short circuit location is near the motor of the motor cable, and codes C1 to C3 represent that the short circuit location is in the motor. In addition, in a case where the code is a numerical value from 00 to 99, the value represents a distance from the power conversion device of the short circuit location on the motor cable. The correspondence table of FIG. 17 may be posted in a manual of the power conversion device or in the side surface of the power conversion device, so that the user can easily understand the correspondence between the code and the short circuit location information.

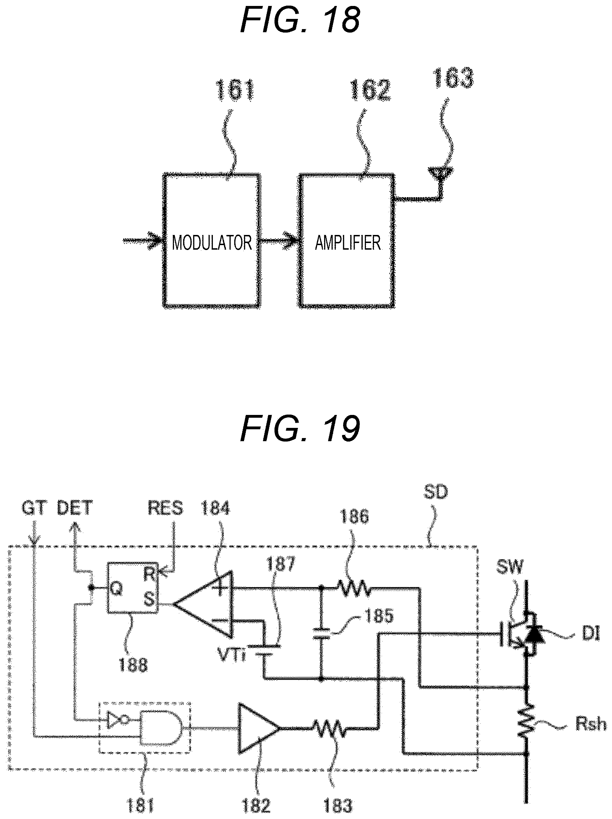

FIG. 18 is a diagram illustrating a configuration of the transmitting device 109. The transmitting device 109 is configured by a modulator 161, an amplifier 162, and an antenna 163. The short circuit location determination result sent from the control circuit 105 and the short circuit phase number are modulated by the modulator 161, are amplified in power by the amplifier 162, and are wirelessly transmitted to the outside through the antenna 163. While not illustrated, another device or system receives the wirelessly transmitted signal, and demodulates the signal so as to obtain the information of the short circuit location determination result and the short circuit phase number. In addition, a tablet terminal may be used, and application software with the correspondence table of FIG. 17 embedded may be installed in the tablet terminal, so that the short circuit location information is displayed in the screen of the tablet terminal.

FIG. 19 is a diagram illustrating a configuration of the switch driver circuits SDu, SDv, SDw, SDx, SDy, and SDz of another protection circuit scheme. The configurations of the switches are common. Therefore, in FIG. 2, suffixes u, v, w, x, y, and z of symbols SW, DI, and SD will be omitted. The switch driver circuit SD is configured by a logic circuit 181, a gate drive amplifier 182, a gate resistor 183, a comparator 184, the capacitor 185, a filter resistor 186, a constant voltage source 187, and a latch circuit 188. In addition, a shunt resistor Rsh is inserted and provided in the wire on the emitter electrode side of the switch SW. The gate drive amplifier 182 and the gate resistor 183 are used to control turning ON/OFF of the switch SW to be connected. In a case where a gate signal GT from the control circuit 105 is "H", the gate drive amplifier 182 outputs a gate ON voltage to turn on the switch SW. In a case where the gate signal GT is "L", the gate drive amplifier 182 outputs a gate OFF voltage to turn off the switch SW. The gate resistor 183 controls a switching speed. On the other hand, the comparator 184, the capacitor 185, the filter resistor 186, the constant voltage source 187, and the latch circuit 188 form the overcurrent detection circuit. The overcurrent detection circuit is a circuit of a current detection scheme using a shunt resistor. The constant voltage source 187 is a voltage source of the threshold voltage VTi. The threshold voltage VTi is set with the same voltage value as the voltage drop of the shunt resistor Rsh when it is determined that the current flowing to the switch is overcurrent. If the overcurrent occurs, the voltage drop of the shunt resistor Rsh exceeds the threshold voltage VT, and the comparator 184 outputs "H". Then, the output Q of the latch circuit 188 becomes "H", the gate signal GT is invalidated by the logic circuit 181, the switch is forcibly blocked, and the driver circuit SD enters a state where an overcurrent protection function operates. In addition, the overcurrent detection is transferred as an overcurrent detection signal DET to the control circuit 105. The overcurrent protection function is released when a reset signal from the control circuit 105 is input to RES to reset the latch circuit 188. As described above, the switch driver circuit illustrated in FIG. 19 serves as a gate driver circuit equipped with the overcurrent protection function, and can transfer the overcurrent detection to the control circuit 105 immediately after the overcurrent detection caused by a short circuit. Further, the capacitor 185 and the filter resistor 186 are provided to prevent an error operation caused by noises, and generates a delay in the overcurrent detection time. In a case where the delay time is in such a degree that cannot be ignored, the delay time can be derived in an overcurrent detection time measurement operation and can be corrected.

Second Embodiment

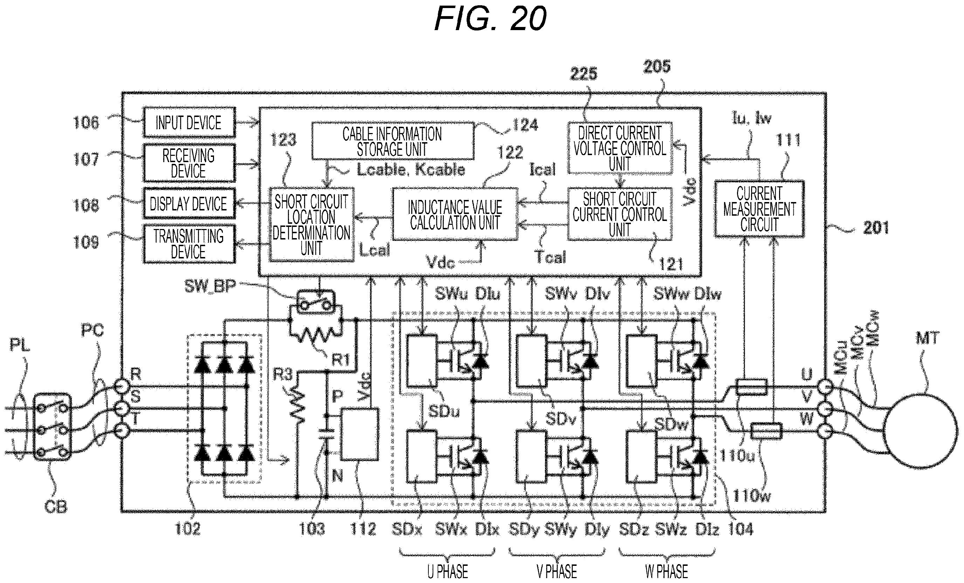

FIG. 20 illustrates a diagram illustrating a configuration of a second embodiment of a power conversion device of the invention. A power conversion device 201 includes a forward converter circuit 102 which receives alternating current power to supply power to a motor, a capacitor 103, and a reverse converter circuit 104. In addition, the power conversion device 201 includes a control circuit 205 to control the power conversion device 201, an input device 106 to manually input information to the control circuit 205, a receiving device 107 to receive information from an external system, a display device 108 to display output information from the control circuit 205, and a transmitting device 109 to transmit information to an external system.

The forward converter circuit 102 is configured by six diodes, converts alternating current power which is sent through power lines PL, a circuit breaker CB, and a power source cable PC and input from input terminals R, S, and T into direct current power, and outputs the direct current power to the direct current power lines indicated with nodes P and N. With the rectification of the diodes of the forward converter circuit 102, a direct current voltage is generated in which a positive voltage appears in a direct current voltage line on a side of the node P and a negative voltage appears in a direct current voltage line on a side of the node N. The capacitor 103 is connected to the direct current voltage lines at the nodes P and N, and keeps (smoothens) the voltage between the lines even if a current changes steeply. The reverse converter circuit 104 converts the direct current power to the alternating current power to drive the motor, and outputs the alternating current power to output terminals U, V, and W.

A resistor R1 and a bypass switch SW_BP are connected in parallel between the forward converter circuit 102 and the node P. The resistor R1 is a resistor for limiting an inrush current into the capacitor 103 which is generated at the time of turning on the power. The switch SW_BP bypasses the current by being turned on after limiting the inrush current. The switch SW_BP may be configured by semiconductor transistors or electromagnetic relays. A discharge resistor R3 is connected between the nodes P and N, and the capacitor 103 is discharged when the circuit breaker CB blocks the power source.

The reverse converter circuit 104 is configured by three half-bridge circuits of U, V, and W phases. The half-bridge circuit of the U phase is configured by an upper arm where a switch SWu and a diode DIu are connected in reverse parallel, and a lower arm where a switch SWx and a diode DIx are connected in reverse parallel. Similarly, the half-bridge circuit of the V phase is configured by a switch SWv, a diode DIv, a switch SWy, and a diode DIy. The half-bridge circuit of the W phase is configured by a switch SWw, a diode DIw, a switch SWz, and a diode DIz. In FIG. 1, IGBTs are used as switches, but MOSFETs may be used. In addition, normally silicon is employed for the semiconductor device, but SiC (silicon carbide) or GaN (gallium nitride) of a wide-gap semiconductor may be used to reduce loss. All of the switches SWu, SWv, SWw, SWx, SWy, and SWz are connected to switch driver circuits SDu, SDv, SDw, SDx, SDy, and SDz respectively. Each switch driver circuit is connected to electrodes of emitter, gate, and collector of each switch. The emitter, the gate, and the collector are names of the electrodes of an IGBT. In the case of MOSFET, the names correspond to a source, a gate, and a drain. In all of the switch driver circuits, there are built in a gate driver circuit which controls the gate voltage of the switch to turn the switch on or off, and an overcurrent protection circuit which detects an overcurrent flowing in the switch to block the switch at a high speed (turning off). The switch driver circuit includes a communication unit with respect to the control circuit 205. The communication unit is used to transfer an overcurrent detection signal from the switch driver circuit to the control circuit 205 when an ON/OFF control signal of a switch is transferred from the control circuit 205 to the switch driver circuit.

The power conversion device 101 includes two current sensors 110u and 110w to measure output current values of the respective phases between the reverse converter circuit 104 and the output terminals U and W, and a current measurement circuit 111 to measure these measurement values. The current sensors 110u and 110w measure the current values output from the output terminals U and W, and transfer these values as analog voltages or currents to the current measurement circuit 111. The current measurement circuit 111 samples and digitizes the analog information, and transmits the information as measurement current values Iu and Iw to the control circuit 205. In addition, the power conversion device 101 includes a voltage measurement circuit 112 which measures a voltage between the nodes P and N of the direct current voltage line (that is, both electrodes of the capacitor 103). The voltage measurement circuit 112 measures and digitizes the direct current voltage between the nodes P and N, and transmits the value as a direct current voltage value Vdc to the control circuit 205. The current measurement circuit 111 and the voltage measurement circuit 112 may be configured by a typical sampling circuit and an A/D conversion circuit.

The control circuit 205 includes a short circuit current control unit 121, an inductance value calculation unit 122, a short circuit location determination unit 123, a cable information storage unit 124, and a direct current voltage measurement unit 225 in order to determine a short circuit location on an output side (motor cables MCu, MCv, and MCw and a motor MT) of the power conversion device 101. The short circuit current control unit 121 controls the switches in the reverse converter circuit 104 at the time of inspecting a short circuit location on the basis of current value information from the current measurement circuit 111 and overcurrent detection information from all of the switch driver circuits SD in the reverse converter circuit 104 to control the short circuit current. In addition, the short circuit current control unit 121 transmits current value information Ical and time information Tcal obtained at the time of controlling the current to the inductance value calculation unit 122. The inductance value calculation unit 122 calculates an inductance value Lcal from Ical, Tcal, and the direct current voltage information Vdc, and sends the inductance value to the short circuit location determination unit 123. The short circuit location determination unit 123 estimates a short circuit location on the basis of the transmitted inductance value Lcal and the cable information stored in the cable information storage unit 124, and transmits the determination result to the display device 108 and the transmitting device 109. The direct current voltage measurement unit 225 transmits a trigger to the short circuit current control unit 121 to start the short circuit location inspection on the basis of the direct current voltage information Vdc. Further, the control circuit 205 has a typical function for the PWM driving of the motor, but since it is not related to the operation of the invention, the description thereof will be omitted. In addition, elements which can be configured only by logic circuits may be realized in software using a microcomputer or a programmable logic.

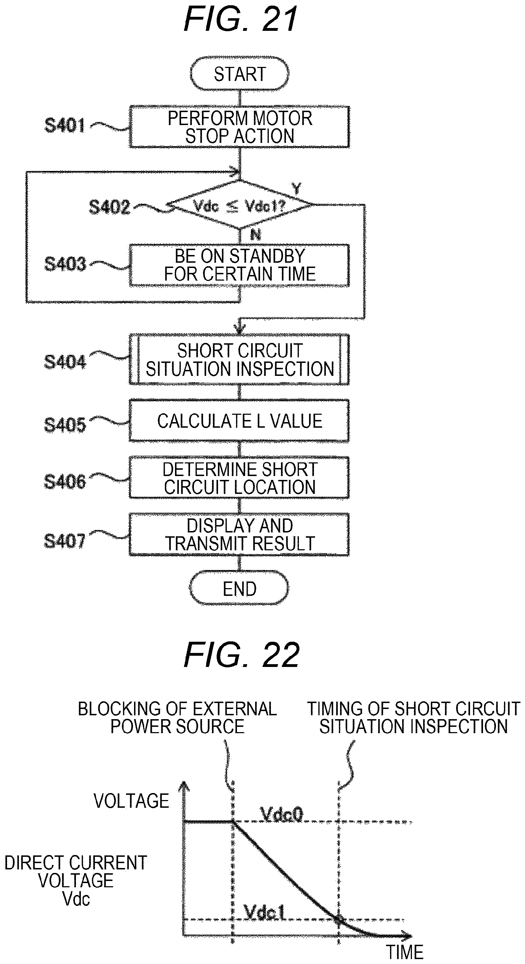

FIG. 21 illustrates a first flowchart of a short circuit location determination in the second embodiment of the invention. The flow of FIG. 21 is started by an overcurrent detection signal from the protection circuit as the short circuit occurs, and a trigger from the input device 106 or the receiving device 107. After starting, the control circuit 205 performs a motor stop action (S401). Specifically, the power supplying to the motor is stopped by turning off all the switches of the forward converter circuit 102, and this state is kept until the current values of all the phases measured by the current measurement circuit 111 become 0. After the motor stops, the process enters a standby state while monitoring the direct current voltage, and is on standby until the external power supplied from the input terminals R, S, and T is blocked (S402 to 403). If the external power source is blocked by blocking the circuit breaker CB, the direct current voltage of the capacitor 103 is lowered by the discharge resistor R3. When the direct current voltage Vdc measured by the voltage measurement circuit 112 is lowered than the predetermined voltage Vdc1, the short circuit current control unit 121 performs the inspection on the short circuit situation. In a case where the short circuit information is successfully acquired, the current value information Ical and the time information Tcal are supplied to the inductance value calculation unit 122 (S404). The inductance value calculation unit 122 calculates the inductance value Lcal from Ical, Tcal, and the direct current voltage information Vdc, and sends the calculated value to the short circuit location determination unit 123 (S405). The short circuit location determination unit 123 estimates the short circuit location on the basis of the transmitted inductance value Lcal and the cable information stored in the cable information storage unit 124 (S406). The determination result is transmitted to the display device 108 and the transmitting device 109 (S407).

FIG. 22 illustrates a change in the direct current voltage (Vdc) in the flow of the short circuit location determination of FIG. 21. At the time of driving the motor, the control circuit 205 turns on the circuit breaker CB to supply power to the motor. The direct current voltage Vdc is kept to Vdc0 by the external power supply and the rectification of the forward converter circuit 102. If the external power source is blocked by blocking the circuit breaker CB, the direct current voltage Vdc is lowered by the discharge resistor R3. At timing when the direct current voltage is lower than Vdc1, the direct current voltage measurement unit 225 triggers the short circuit current control unit 121 to perform the inspection on the short circuit situation. The direct current voltage is lowered by the discharging of the discharge resistor R3 even during the short circuit situation inspection. However, a CR time constant determined by the capacitor 103 and the discharge resistor R3 is sufficiently increased more than the time for the short circuit inspection. Therefore, it is possible to consider that the direct current voltage Vdc is fixed to the value Vdc1.

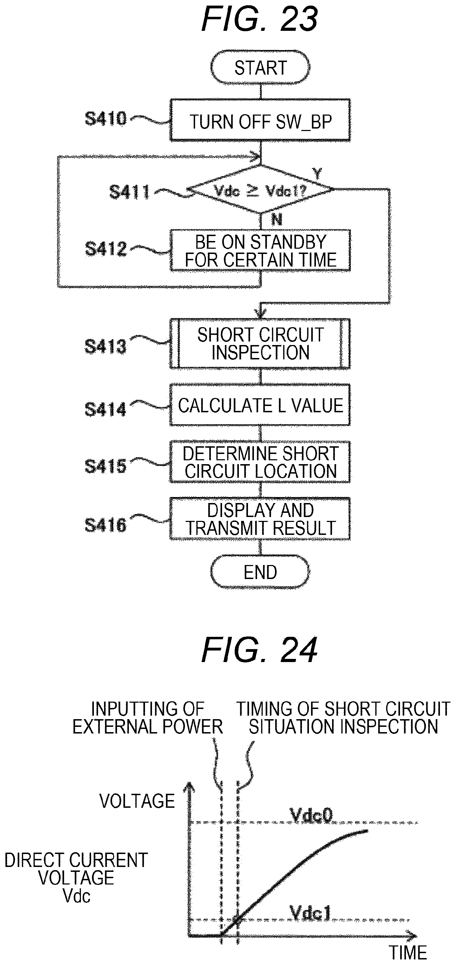

FIG. 23 illustrates a second flowchart of a short circuit location determination in the second embodiment of the invention. The flow of FIG. 23 is started when the external power starts to be supplied by turning on the circuit breaker CB, or a trigger from the input device 106 or the receiving device 107 before the external power starts to be supplied. The switch SW_BP is in an OFF state, and the charging to the capacitor 103 from the external power source is performed by a charging current flowing to the resistor R1 (S410). After starting, the process enters a standby state while monitoring the direct current voltage (S411 to S412). When the direct current voltage Vdc measured by the voltage measurement circuit 112 is larger than the predetermined voltage Vdc1, the short circuit current control unit 121 performs the inspection on the short circuit situation. In a case where the short circuit information is successfully acquired, the current value information Ical and the time information Tcal are supplied to the inductance value calculation unit 122 (S413). The inductance value calculation unit 122 calculates the inductance value Lcal from Ical, Tcal, and the direct current voltage information Vdc, and sends the calculated value to the short circuit location determination unit 123 (S414). The short circuit location determination unit 123 estimates the short circuit location on the basis of the transmitted inductance value Lcal and the cable information stored in the cable information storage unit 124 (S415). The determination result is transmitted to the display device 108 and the transmitting device 109 (S416).

FIG. 24 illustrates a change in the direct current voltage (Vdc) in the flow of the short circuit location determination of FIG. 23. If the external power starts to be supplied by turning on the circuit breaker CB, the direct current rectified by the forward converter circuit 102 flows through the resistor R1 to charge the capacitor 103. The direct current voltage Vdc is increased as the charging is progressed. At timing when the direct current voltage is larger than Vdc1, the direct current voltage measurement unit 225 triggers the short circuit current control unit 121 to perform the inspection on the short circuit situation. The direct current voltage is increased by the charging current of the resistor R1 even during the

**EP 3 595 159 B1**

short circuit situation inspection. However, a CR time constant determined by the capacitor 103 and the resistor R1 is sufficiently increased more than the time for the short circuit inspection. Therefore, it is possible to consider that the direct current voltage Vdc is fixed to the value Vdc1.

[Application of Invention]

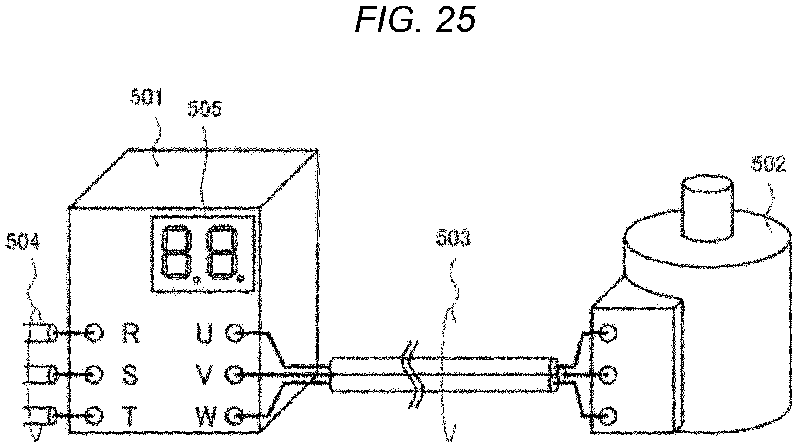

FIG. 25 illustrates an example that the invention is applied as an industrial inverter. A power conversion device 501 of the invention and a drive motor 502 are connected by a motor cable 503. The power conversion device 501 receives power from the outside through an alternating current power source cable 504. The motor 502 may be used by driving various industrial machines such as an air conditioner, a compressor, a conveyer, and an elevator. In a case where the interphase short circuit occurs in the motor 502 or on the cable 503, information of the short circuit location is displayed in a display device 505 of the power conversion device 501, and the short circuit location is notified to an external system in a wireless manner.

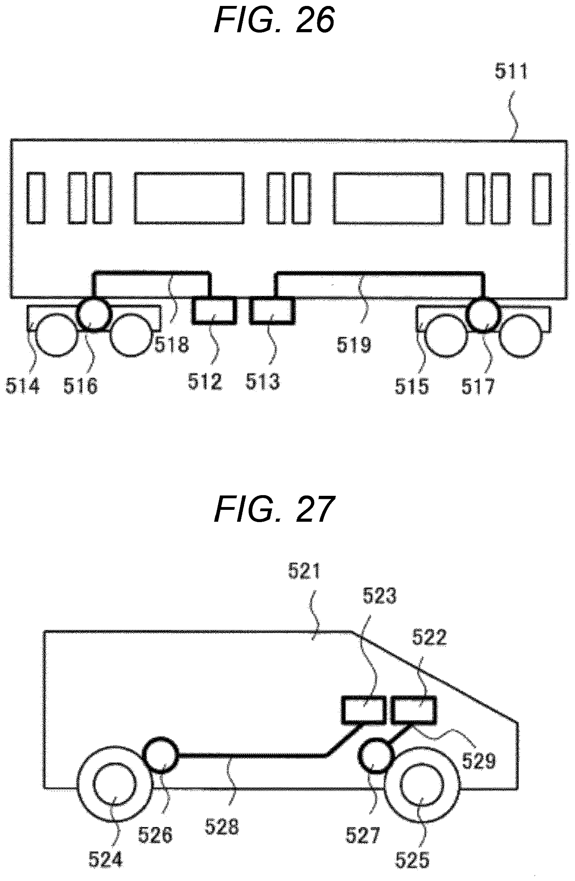

FIG. 26 illustrates an example that the invention is applied to a railway vehicle. Power conversion devices 512 and 513 of the invention is installed below the floor of a railway vehicle 511. Dollies 514 and 515 of the railway vehicle 511 are attached with driving motors 516 and 517. The motor and the power conversion device are connected by motor cables 518 and 519. In a case where the interphase short circuit occurs in the motors 516 and 517 or on the motor cables 518 and 519, information of the short circuit location is displayed in the display devices of the power conversion devices 512 and 513, and the location is notified to an external system in a wireless manner.

FIG. 27 illustrates an example that the invention is applied to a vehicle equipped with an electric motor. Power conversion devices 522 and 523 of the invention are installed in a vehicle 521. In addition, motors 526 and 527 are installed to drive wheels 524 and 525, and are connected by the power conversion device and motor cables 528 and 529. In a case where the interphase short circuit occurs in the motors 526 and 527 or on the motor cables 528 and 529, information of the short circuit location is displayed in the display devices of the power conversion devices 522 and 523, and the short circuit location is notified to an external system in a wireless manner.

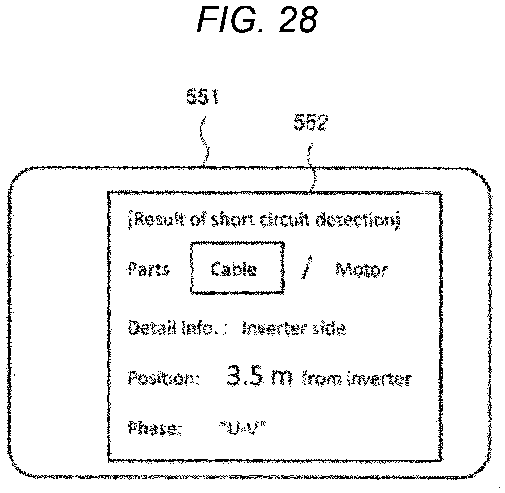

FIG. 28 illustrates an example of the tablet terminal which displays a determination result of the invention. A liquid crystal display screen 552 is provided in a tablet terminal 551, the information of the short circuit location is displayed in the liquid crystal display screen 552 according to a received code depending on an installed application.

Reference Signs List

| | |
|---|---|
| SW, SWu, SWv, SWw, SWx, SWy, SWz | switch |
| DI, DIu, DIv, DIw, DIx, DIy, DIz | diode |
| SD, SDu, SDv, SDw, SDx, SDy, SDz | switch driver circuit |
| MC, MCu, MCv, MCw | motor cable |
| MT | motor |
| PC | power source cable |
| PL | power line |
| CB | circuit breaker |
| SW_PW | power source switch |
| SW_DC | discharge switch |
| SW_BP | bypass switch |
| R1, R2, R3 | resistor |
| Rsh | shunt resistor |
| 101 | power conversion device |
| 102 | forward converter circuit |
| 103 | capacitor |
| 104 | reverse converter circuit |
| 105 | control circuit |
| 106 | input device |
| 107 | receiving device |
| 108 | display device |
| 109 | transmitting device |
| 110u, 110w | current sensor |
| 111 | current measurement circuit |
| 112 | voltage measurement circuit |

| 121 | short circuit current control unit |
| 122 | inductance value calculation unit |
| 123 | short circuit location determination unit |
| 124 | cable information storage unit |
| 125 | direct current voltage control unit |
| 131 | logic circuit |
| 132 | gate drive amplifier |
| 133 | gate resistor |
| 134 | comparator |
| 135 | capacitor |
| 136 | capacitor charging resistor |
| 137 | capacitor discharging switch |
| 138 | diode |
| 139, 140 | constant voltage source |
| 141 | latch circuit |
| 151 | decoder |
| 152 | LED driver |
| 153 | LED segment |
| 161 | modulator |
| 162 | amplifier |
| 163 | antenna |
| 181 | logic circuit |
| 182 | gate drive amplifier |
| 183 | gate resistor |
| 184 | comparator |
| 185 | capacitor |
| 186 | filter resistor |
| 187 | constant voltage source |
| 188 | latch circuit |
| 201 | power conversion device |
| 205 | control circuit |
| 225 | direct current voltage measurement unit |

**Claims**

1. A power conversion device (101,201,501,512,513,522) which includes a plurality of semiconductor switch elements (SW,SWu,SWv,SWw,SWx,SWy,SWz) and is configured to drive, by controlling turning on or off the semiconductor switch elements, a three-phase motor (MT), the three-phase motor being configured to be connected to the power conversion device by three-phase cables, the power conversion device comprising:

   a first, forward converter circuit (102) which is configured to convert alternating current power from a power source into direct current power;
   a second, reverse converter circuit (104) comprising three output terminals and three half-bridge circuits to control current to be supplied to the three-phase motor;
   wherein each of the half-bridge circuits is associated with one of the output terminals and comprises an upper arm and a lower arm, each of the arms comprising one of the plurality of semiconductor switch elements, and each of the output terminals is to be connected to one of the three-phase cables,
   a plurality of driver circuits (SD,SDu,SDv,SDw,SDx,SDy,SDz) configured to drive the plurality of semiconductor switch elements of the half-bridge circuits;
   a control circuit (105,205) configured to control the driver circuit,
   wherein a direct current voltage is derived from the direct current power;
   a current measurement unit (111) configured to measure output current values of a plurality of output terminals of the three output terminals of the second converter circuit; and
   an information output unit configured to notify an inner situation of the device to an outside,
   wherein, when a short circuit occurred in the cable or the motor is inspected, the control circuit is configured to turn on the semiconductor switch elements, one of which is on an upper arm and the other one of which is on a lower arm of a different half-bridge circuit than the upper arm to generate a current for short circuit investigation in the cable, and is configured to calculate a round-trip inductance value of the cable on the basis of a time during which both the switch elements are turned on and a current measurement value of the current measurement unit, and is configured to determine the short circuit location from the round-trip inductance value, and wherein the information output unit is configured to notify a determination result of the short circuit location to the outside,

**characterized in that** the

control circuit is configured to control the direct current voltage to be supplied to the second converter circuit to reduce the direct current voltage to be supplied to the second converter circuit to a voltage lower than the direct current voltage to be supplied when the motor is driven.

2. The power conversion device according to claim 1, further comprising:

a voltage sensor (112) which is adapted to be used to measure the direct current voltage to be supplied to the second converter circuit,

wherein, when the short circuit location occurred in the cable or the motor is inspected, or the direct current voltage starts to be supplied or blocked with respect to the second converter circuit, a voltage value measured by the voltage sensor is a predetermined value lower than a direct current voltage value when the motor is driven.

3. The power conversion device according to claim 1,

wherein the control circuit includes a cable information storage unit, and is adapted to convert the round-trip inductance value into a distance on the cable up to the short circuit location from the power conversion device using an inductance value per unit length of the cable previously stored in the cable information storage unit as a coefficient, and is adapted to notify the distance from the information output unit to the outside.

4. The power conversion device according to claim 3, further comprising:

an information input unit,

wherein cable diameter information is input from the information input unit, and an inductance value per unit length of the cable is calculated from the cable diameter information.

5. The power conversion device according to claim 1,

wherein the control circuit includes a cable information storage unit, and is adapted to determine that the short circuit location is on the cable in a case where the calculated round-trip inductance value is smaller than the round-trip inductance value of a total cable length previously stored in the cable information storage unit or on the three-phase motor in a case where the calculated round-trip inductance value is larger, and is adapted to notify the determination from the information output unit to the outside.

6. The power conversion device according to claim 3, further comprising:

an information input unit,

wherein diameter information of the cable and length information of the cable are input from the information input unit, and a round-trip inductance value of a total length of the cable is calculated from the diameter information of the cable and the length information of the cable.

7. The power conversion device according to claim 1,

wherein the control circuit is adapted to acquire the current measurement value from the current measurement unit in a state where any one of the semiconductor switch elements is turned off after both the switch elements are turned on.

8. The power conversion device according to claim 1,

wherein the driver circuit includes an overcurrent protection circuit which has an overcurrent protection function of detecting an overcurrent exceeding a predetermined overcurrent threshold value using a comparator circuit, and of turning off at least one of the semiconductor switch elements when the overcurrent is detected.

9. The power conversion device according to claim 8,

wherein, in a case where the overcurrent protection function operates, the control circuit is adapted to measure a time taken until the overcurrent protection circuit detects the overcurrent after both the semiconductor switch elements start to be turned on, and is adapted to calculate the round-trip inductance value of the cable on the basis of the measured time and the overcurrent threshold value.

10. The power conversion device according to claim 8,
wherein the control circuit is adapted to repeatedly turn on both the semiconductor switch elements, gradually lengthens a turning-on time width, and is adapted to calculate the round-trip inductance value of the cable on the basis of the time width when the overcurrent protection function operates and the overcurrent threshold value.

11. The power conversion device according to claim 8,
wherein the comparator circuit of the overcurrent protection circuit is adapted to measure a voltage drop in the semiconductor switch element, and is adapted to compare the voltage drop with a reference voltage source to detect an overcurrent.

12. The power conversion device according to claim 8, further comprising:

a resistor which is connected to the semiconductor switch element in series,
wherein the comparator circuit of the overcurrent protection circuit is adapted to measure a voltage drop in the resistor, and is adapted to compare the voltage drop with a reference voltage source to detect an overcurrent.

13. A short circuit location determining method of a three-phase cable or a three-phase motor (MT) which is connected by the three-phase cable to a power conversion device(101, 201, 501, 512, 513, 522), the power conversion device driving the three-phase motor and including
a first, forward converter circuit (102) which is configured to convert alternating current power from a power source into direct current power,
a second, reverse converter circuit (104) comprising three output terminals and three half-bridge circuits to control a current to be supplied to the three-phase motor
wherein each of the half-bridge circuits is associated with one of the output terminals and comprises an upper arm and a lower arm, each of the arms comprising one of the plurality of semiconductor switch elements, and each of the output terminals is to be connected to one of the three-phase cables,
a plurality of driver circuits (SD, SDu, SDv, SDw, SDx, SDy, SDz) configured to drive a plurality of semiconductor switch elements of the half-bridge circuits,
a control circuit (105,205) configured to control the driver circuit, wherein a direct current voltage is derived from the direct current power, and
a current measurement unit (111) configured to measure output current values of a plurality of output terminals of the three output terminals of the second converter circuit, the method comprising:

when a short circuit occurred in the cable or the motor is inspected, by the control circuit,
turning on the semiconductor switch elements, one of which is on an upper arm and the other one of which is on a lower arm of a different half-bridge circuit than the upper arm to generate a current for short circuit inspection in the cable, and
calculating a round-trip inductance value of the cable on the basis of a time during which both the switch elements are turned on and a current measurement value of the current measurement unit to determine a short circuit location from the round-trip inductance value,
**characterized by**
reducing the direct current voltage to be supplied to the second converter circuit to a voltage lower than the direct current voltage when the motor is driven.


**Patentansprüche**

1. Leistungswandlervorrichtung (101, 201, 501, 512, 513, 522), die eine Vielzahl von Halbleiterschalterelementen (SW, SWu, SWv, SWw, SWx, SWy, SWz) umfasst und ausgelegt ist, um durch Steuern des Ein- oder Ausschaltens der Halbleiterschalterelemente einen Dreiphasenmotor (MT) anzusteuern, wobei der Dreiphasenmotor ausgelegt ist, um mit der Leistungswandlervorrichtung durch Dreiphasenkabel verbunden zu sein, wobei die Leistungswandlervorrichtung Folgendes umfasst:

eine erste Durchflusswandlerschaltung (102), die ausgelegt ist, um Wechselstromleistung von einer Leistungsquelle in eine Gleichstromleistung umzuwandeln;
eine zweite Sperrwandlerschaltung (104), die drei Ausgangsklemmen und drei Halbbrückenschaltungen umfasst, um Strom so zu steuern, dass er dem Dreiphasenmotor zugeführt wird;
wobei jede der Halbbrückenschaltungen einer der Ausgangsklemmen zugeordnet ist und einen oberen Zweig und einen unteren Zweig umfasst, wobei jeder der Zweige eines der Vielzahl von Halbleiterschalterelementen umfasst und jede der Ausgangsklemmen mit einem der Dreiphasenkabeln zu verbinden ist,
eine Vielzahl von Ansteuerschaltungen (SD, SDu, SDv, SDw, SDx, SDy, SDz), die ausgelegt sind, um die Vielzahl von Halbleiterschalterelementen der Halbbrückenschaltungen anzusteuern;
eine Steuerschaltung (105, 205), die ausgelegt ist, um die Ansteuerschaltung zu steuern,
wobei eine Gleichspannung von der Gleichstromleistung abgeleitet ist;
eine Strommesseinheit (111), die ausgelegt ist, um Ausgangsstromwerte einer Vielzahl von Ausgangsklemmen der drei Ausgangsklemmen der zweiten Wandlerschaltung zu messen; und
eine Informationsausgabeeinheit, die ausgelegt ist, um eine innere Situation der Vorrichtung an eine Außenseite zu melden,
wobei, wenn ein Kurzschluss in dem Kabel auftritt oder der Motor geprüft wird, die Steuerschaltung ausgelegt ist, um die Halbleiterschalterelemente einzuschalten, wobei sich eines davon auf einem oberen Zweig befindet und das andere davon sich auf einem unteren Zweig einer unterschiedlichen Halbbrückenschaltung als der obere Zweig befindet, um einen Strom für eine Kurzschlussuntersuchung in dem Kabel zu erzeugen, und ausgelegt ist, um einen Umlauf-Induktivitätswert des Kabels auf der Grundlage einer Zeit, in der beide der Schaltelemente eingeschaltet sind, und einen Strommesswert der Strommesseinheit zu berechnen, und ausgelegt ist, um aus dem Umlauf-Induktivitätswert zu bestimmen, wo sich die Kurzschlussstelle befindet, und wobei die Informationsausgabeeinheit ausgelegt ist, um ein Ergebnis des Bestimmens, wo sich die Kurzschlussstelle befindet, an die Außenseite zu melden,
**dadurch gekennzeichnet, dass** die
Steuerschaltung ausgelegt ist, um die Gleichspannung, die der zweiten Wandlerschaltung zuzuführen ist, zu steuern, um die Gleichspannung, die der zweiten Wandlerschaltung zuzuführen ist, auf eine Spannung, die niedriger als die Gleichspannung ist, die zuzuführen ist, wenn der Motor angesteuert wird, zu verringern.

2. Leistungswandlervorrichtung nach Anspruch 1, die ferner Folgendes umfasst:

einen Spannungssensor (112) der ausgelegt ist, um verwendet zu werden, um die Gleichspannung, die der zweiten Wandlerschaltung zuzuführen ist, zu messen,
wobei, wenn sich die Kurzschlussstelle in dem Kabel befindet oder der Motor geprüft wird, oder die Gleichspannung beginnt, in Bezug auf die zweite Wandlerschaltung versorgt oder blockiert zu werden, ein Spannungswert, der durch den Spannungssensor gemessen wird, ein vorbestimmter Wert ist, der kleiner als ein Gleichspannungswert ist, wenn der Motor angesteuert wird.

3. Leistungswandlervorrichtung nach Anspruch 1,
wobei die Steuerschaltung eine Kabelinformationsspeichereinheit umfasst und ausgelegt ist, um den Umlauf-Induktivitätswert in einen Abstand auf dem Kabel von der Leistungswandlervorrichtung bis zu der Kurzschlussstelle, unter Verwendung eines Induktivitätswerts pro Einheitslänge des Kabels umzuwandeln, der zuvor in der Kabelinformationsspeichereinheit als Koeffizient gespeichert wurde, und ausgelegt ist, um den Abstand von der Informationsausgabeeinheit an die Außenseite zu melden.

4. Leistungswandlervorrichtung nach Anspruch 3, die ferner Folgendes umfasst:

eine Informationseingabeeinheit,
wobei Kabeldurchmesserinformationen von der Informationseingabeeinheit eingegeben werden und ein Induktivitätswert pro Einheitslänge des Kabels von den Kabeldurchmesserinformationen berechnet wird.

5. Leistungswandlervorrichtung nach Anspruch 1,
wobei die Steuerschaltung eine Kabelinformationenspeichereinheit umfasst und ausgelegt ist, um zu bestimmen, dass sich die Kurzschlussstelle auf dem Kabel befindet, in einem Fall, dass der berechnete Umlauf-Induktivitätswert kleiner als der Umlauf-Induktivitätswert einer zuvor in der Kabelinformationenspeichereinheit oder auf dem Dreiphasenmotor gespeicherten Gesamtkabellänge ist, wobei der berechnete Umlauf-Induktivitätswert größer ist, und ausgelegt ist, um die Bestimmung von der Informationsausgabeeinheit an die Außenseite zu melden.

6. Leistungswandlervorrichtung nach Anspruch 3, die ferner Folgendes umfasst:

eine Informationseingabeeinheit,

wobei Durchmesserinformationen des Kabels und Längeninformationen des Kabels von der Informationseingabeeinheit eingegeben werden und ein Umlauf-Induktivitätswert einer Gesamtlänge des Kabels von den Durchmesserinformationen des Kabels und den Längeninformationen des Kabels berechnet wird.

7. Leistungswandlervorrichtung nach Anspruch 1,
wobei die Steuerschaltung ausgelegt ist, um den Strommesswert von der Strommesseinheit in einem Zustand zu erfassen, in dem ein beliebiges der Halbleiterschalterelemente abgeschaltet wird, nachdem beide Schalterelemente eingeschaltet wurden.

8. Leistungswandlervorrichtung nach Anspruch 1,
wobei die Ansteuerschaltung eine Überstromschutzschaltung umfasst, die eine Überstromschutzfunktion zum Detektieren eines Überstroms aufweist, der einen vordefinierten Überstromgrenzwert überschreitet, wobei eine Komparatorschaltung verwendet wird, und zum Abschalten zumindest eines der Halbleiterschalterelemente, wenn der Überstrom detektiert wird.

9. Leistungswandlervorrichtung nach Anspruch 8,
wobei im Fall des Betriebs einer Überstromschutzfunktion die Steuerschaltung ausgelegt ist, um eine benötigte Zeit zu messen, bis die Überstromschutzschaltung den Überstrom detektiert, nachdem beide der Halbleiterschalterelemente beginnen, eingeschaltet zu werden, und ausgelegt ist, um den Umlauf-Induktivitätswert des Kabels auf der Grundlage der gemessenen Zeit und des Überstromschwellwerts zu berechnen.

10. Leistungswandlervorrichtung nach Anspruch 8,
wobei die Steuerschaltung ausgelegt ist, um beide Halbleiterschalterelemente wiederholt einzuschalten, allmählich eine Zeitspanne des Einschaltens verlängert, und ausgelegt ist, um den Umlauf-Induktivitätswert des Kabels auf der Grundlage der Zeitspanne, wenn die Überstromschutzfunktion in Betrieb ist, und des Überstromgrenzwerts zu berechnen.

11. Leistungswandlervorrichtung nach Anspruch 8,
wobei die Komparatorschaltung der Überstromschutzschaltung ausgelegt ist, um einen Spannungsabfall in dem Halbleiterschalterelement zu messen, und ausgelegt ist, um den Spannungsabfall mit einer Referenzspannungsquelle zu vergleichen, um einen Überstrom zu detektieren.

12. Leistungswandlervorrichtung nach Anspruch 8, die ferner Folgendes umfasst:

    einen Widerstand, der mit dem Halbleiterschalterelement in Reihe verbunden ist,
    wobei die Komparatorschaltung der Überstromschutzschaltung ausgelegt ist, um einen Spannungsabfall in dem Widerstand zu messen, und ausgelegt ist, um den Spannungsabfall mit einer Referenzspannungsquelle zu vergleichen, um einen Überstrom zu detektieren.

13. Kurzschlussposition-Bestimmungsverfahren eines Dreiphasenkabels oder eines Dreiphasenmotors (MT), der durch das Dreiphasenkabel mit einer Leistungswandlervorrichtung (101, 201, 501, 512, 513, 522) verbunden ist, wobei die Leistungswandlervorrichtung den Dreiphasenmotor ansteuert und Folgendes umfasst:

    eine erste Durchflusswandlerschaltung (102), die ausgelegt ist, um Wechselstromleistung von einer Leistungsquelle in Gleichstrom umzuwandeln,
    eine zweite Sperrwandlerschaltung (104), die drei Ausgangsklemmen und drei Halbbrückenschaltungen umfasst, um einen Strom zu steuern, der dem Dreiphasenmotor zuzuführen ist,
    wobei jede der Halbbrückenschaltungen einer Ausgangsklemme zugeordnet ist und einen oberen Zweig und einen unteren Zweig umfasst, wobei jeder der Zweige eines der Vielzahl von Halbleiterschalterelementen umfasst, und jede der Ausgabeklemmen mit einem der Dreiphasenkabel zu verbinden ist,
    eine Vielzahl von Ansteuerschaltungen (SD, SDu, SDv, SDw, SDx, SDy, SDz), die ausgelegt sind, um eine Vielzahl von Halbleiterschalterelementen der Halbbrückenschaltungen anzusteuern,
    eine Steuerschaltung (105, 205), die ausgelegt ist, um die Ansteuerschaltung zu steuern, wobei eine Gleichspannung von der Gleichstromleistung abgeleitet ist, und
    eine Strommesseinheit (111), die ausgelegt ist, um Ausgangsstromwerte einer Vielzahl von Ausgangsklemmen der drei Ausgangsklemmen der zweiten Wandlerschaltung zu messen, wobei das Verfahren Folgendes umfasst:

    wenn ein Kurzschluss in dem Kabel aufgetreten ist oder der Motor geprüft wird, das Einschalten der Halbleiterschalterelemente durch die Steuerschaltung, wobei sich eines an einem oberen Zweig und das andere davon an einem unteren Zweig einer unterschiedlichen Halbbrückenschaltung als der obere Zweig befindet, um einen Strom für die Prüfung des Kurzschlusses in dem Kabel zu erzeugen, und

das Berechnen eines Umlauf-Induktivitätswerts des Kabels auf der Grundlage einer Zeit, während der beide der Schalterelemente eingeschaltet sind und eines Strommesswerts der Strommesseinheit, um von dem Umlauf-Induktivitätswert eine Kurzschlussstelle zu bestimmen,

**gekennzeichnet durch**
das Verringern der Gleichspannung, die der zweiten Wandlerschaltung zuzuführen ist, auf eine Spannung, die kleiner als die Gleichspannung ist, wenn der Motor angesteuert wird.

## Revendications

1. Dispositif de conversion de puissance (101, 201, 501, 512, 513, 522) qui inclut une pluralité d'éléments de commutation à semi-conducteurs (SW, SWu, SWv, SWw, SWx, SWy, SWz) et est configuré de manière à entraîner, en commandant la mise sous tension ou la mise hors tension des éléments de commutation à semi-conducteurs, un moteur triphasé (MT), le moteur triphasé étant configuré de manière à être connecté au dispositif de conversion de puissance par des câbles triphasés, le dispositif de conversion de puissance comprenant :

   un premier circuit convertisseur direct (102) qui est configuré de manière à convertir une puissance en courant alternatif provenant d'une source de puissance en une puissance en courant continu ;
   un second circuit convertisseur inverse (104) comprenant trois bornes de sortie et trois circuits en demi-pont pour commander le courant à fournir au moteur triphasé ;
   dans lequel chacun des circuits en demi-pont est associé à l'une des bornes de sortie et comprend un bras supérieur et un bras inférieur, chacun des bras comprenant un élément de la pluralité d'éléments de commutation à semi-conducteurs, et chacune des bornes de sortie devant être connectée à l'un des câbles triphasés ;
   une pluralité de circuits d'attaque (SD, SDu, SDv, SDw, SDx, SDy, SDz) configurés de manière à exciter la pluralité d'éléments de commutation à semi-conducteurs des circuits en demi-pont ;
   un circuit de commande (105, 205) configuré de manière à commander le circuit d'attaque ;
   dans lequel une tension continue est dérivée de la puissance en courant continu ;
   une unité de mesure de courant (111) configurée de manière à mesurer des valeurs de courant de sortie d'une pluralité de bornes de sortie des trois bornes de sortie du second circuit convertisseur ; et
   une unité de sortie d'informations configurée de manière à notifier une situation interne du dispositif vers l'extérieur ;
   dans lequel, lorsqu'un court-circuit s'est produit dans le câble ou lorsque le moteur est inspecté, le circuit de commande est configuré de manière à mettre sous tension les éléments de commutation à semi-conducteurs, dont l'un est sur un bras supérieur et l'autre sur un bras inférieur d'un circuit en demi-pont différent du bras supérieur pour générer un courant pour une recherche de court-circuit dans le câble, et est configuré de manière à calculer une valeur d'inductance aller-retour du câble sur la base d'un temps pendant lequel les deux éléments de commutation sont sous tension et d'une valeur de mesure de courant de l'unité de mesure de courant, et est configuré de manière à déterminer l'emplacement de court-circuit à partir de la valeur d'inductance aller-retour ; et
   dans lequel l'unité de sortie d'informations est configurée de manière à notifier un résultat de détermination de l'emplacement de court-circuit vers l'extérieur ;
   **caractérisé en ce que** le circuit de commande est configuré de manière à commander la tension continue à fournir au second circuit convertisseur en vue de réduire la tension continue à fournir au second circuit convertisseur à une tension inférieure à la tension continue à fournir lorsque le moteur est entraîné.

2. Dispositif de conversion de puissance selon la revendication 1, comprenant en outre :

   un capteur de tension (112) qui est apte à être utilisé pour mesurer la tension continue à fournir au second circuit convertisseur ;
   dans lequel, lorsque l'emplacement de court-circuit est rencontré dans le câble ou lorsque le moteur est inspecté, ou lorsque la tension continue commence à être fournie ou bloquée par rapport au second circuit convertisseur, une valeur de tension mesurée par le capteur de tension correspond à une valeur prédéterminée inférieure à une valeur de tension continue lorsque le moteur est entraîné.

**EP 3 595 159 B1**

3. Dispositif de conversion de puissance selon la revendication 1,
dans lequel le circuit de commande inclut une unité de stockage d'informations de câble, et est apte à convertir la valeur d'inductance aller-retour en une distance sur le câble jusqu'à l'emplacement de court-circuit, à partir du dispositif de conversion de puissance, en utilisant une valeur d'inductance par unité de longueur du câble précédemment stockée dans l'unité de stockage d'informations de câble, en tant qu'un coefficient, et est apte à notifier la distance à partir de l'unité de sortie d'informations vers l'extérieur.

4. Dispositif de conversion de puissance selon la revendication 3, comprenant en outre :

une unité d'entrée d'informations ;
dans lequel des informations de diamètre de câble sont entrées à partir de l'unité d'entrée d'informations, et une valeur d'inductance par unité de longueur du câble est calculée à partir des informations de diamètre de câble.

5. Dispositif de conversion de puissance selon la revendication 1,
dans lequel le circuit de commande inclut une unité de stockage d'informations de câble, et est apte à déterminer que l'emplacement de court-circuit est sur le câble dans un cas où la valeur d'inductance aller-retour calculée est inférieure à la valeur d'inductance aller-retour d'une longueur totale de câble précédemment stockée dans l'unité de stockage d'informations de câble ou sur le moteur triphasé, dans un cas où la valeur d'inductance aller-retour calculée est supérieure, et est apte à notifier la détermination de l'unité de sortie d'informations vers l'extérieur.

6. Dispositif de conversion de puissance selon la revendication 3, comprenant en outre :

une unité d'entrée d'informations,
dans lequel les informations de diamètre de câble et les informations de longueur de câble sont entrées à partir de l'unité d'entrée d'informations, et une valeur d'inductance aller-retour d'une longueur totale du câble est calculée à partir des informations de diamètre de câble et des informations de longueur de câble.

7. Dispositif de conversion de puissance selon la revendication 1,
dans lequel le circuit de commande est apte à acquérir la valeur de mesure de courant à partir de l'unité de mesure de courant dans un état où l'un quelconque des éléments de commutation à semi-conducteurs est mis hors tension après que les deux éléments de commutation sont mis sous tension.

8. Dispositif de conversion de puissance selon la revendication 1,
dans lequel le circuit d'attaque inclut un circuit de protection contre les surintensités qui présente une fonction de protection contre les surintensités permettant de détecter une surintensité dépassant une valeur de seuil de surintensité prédéterminée en utilisant un circuit comparateur, et de mettre hors tension au moins l'un des éléments de commutation à semi-conducteurs lorsque la surintensité est détectée.

9. Dispositif de conversion de puissance selon la revendication 8,
dans lequel, dans un cas où la fonction de protection contre les surintensités fonctionne, le circuit de commande est apte à mesurer un temps écoulé jusqu'à ce que le circuit de protection contre les surintensités détecte la surintensité après que les deux éléments de commutation à semi-conducteurs commencent à être mis sous tension, et est apte à calculer la valeur d'inductance aller-retour du câble sur la base du temps mesuré et de la valeur de seuil de surintensité.

10. Dispositif de conversion de puissance selon la revendication 8,
dans lequel le circuit de commande est apte à mettre sous tension de manière répétée les deux éléments de commutation à semi-conducteurs, ce qui rallonge progressivement une largeur de temps de mise sous tension, et est apte à calculer la valeur d'inductance aller-retour du câble sur la base de la largeur de temps, lorsque la fonction de protection contre les surintensités opère, et de la valeur de seuil de surintensité.

11. Dispositif de conversion de puissance selon la revendication 8,
dans lequel le circuit comparateur du circuit de protection contre les surintensités est apte à mesurer une chute de tension dans l'élément de commutation à semi-conducteurs, et est apte à comparer la chute de tension à une source de tension de référence en vue de détecter une surintensité.

12. Dispositif de conversion de puissance selon la revendication 8, comprenant en outre :

une résistance qui est connectée en série à l'élément de commutation à semi-conducteurs,

dans lequel le circuit comparateur du circuit de protection contre les surintensités est apte à mesurer une chute de tension dans la résistance, et est apte à comparer la chute de tension à une source de tension de référence en vue de détecter une surintensité.

13. Procédé de détermination d'emplacement de court-circuit d'un câble triphasé ou d'un moteur triphasé (MT) qui est connecté par le câble triphasé à un dispositif de conversion de puissance (101, 201, 501, 512, 513, 522), le dispositif de conversion de puissance entraînant le moteur triphasé et incluant :

un premier circuit convertisseur direct (102) qui est configuré de manière à convertir une puissance en courant alternatif provenant d'une source de puissance en une puissance en courant continu ;

un second circuit convertisseur inverse (104) comprenant trois bornes de sortie et trois circuits en demi-pont pour commander un courant à fournir au moteur triphasé ;

dans lequel chacun des circuits en demi-pont est associé à l'une des bornes de sortie et comprend un bras supérieur et un bras inférieur, chacun des bras comprenant un élément de la pluralité d'éléments de commutation à semi-conducteurs, et chacune des bornes de sortie devant être connectée à l'un des câbles triphasés ;

une pluralité de circuits d'attaque (SD, SDu, SDv, SDw, SDx, SDy, SDz) configurés de manière à exciter la pluralité d'éléments de commutation à semi-conducteurs des circuits en demi-pont ;

un circuit de commande (105, 205) configuré de manière à commander le circuit d'attaque, dans lequel une tension continue est dérivée de la puissance en courant continu ; et

une unité de mesure de courant (111) configurée de manière à mesurer des valeurs de courant de sortie d'une pluralité de bornes de sortie des trois bornes de sortie du second circuit convertisseur, le procédé comprenant les étapes ci-dessous consistant à :

lorsqu'un court-circuit s'est produit dans le câble ou lorsque le moteur est inspecté, par le biais du circuit de commande, mettre sous tension les éléments de commutation à semi-conducteurs, dont l'un est sur un bras supérieur et l'autre sur un bras inférieur d'un circuit en demi-pont différent du bras supérieur pour générer un courant pour une recherche de court-circuit dans le câble ; et

calculer une valeur d'inductance aller-retour du câble sur la base d'un temps pendant lequel les deux éléments de commutation sont sous tension et d'une valeur de mesure de courant de l'unité de mesure de courant, en vue de déterminer un emplacement de court-circuit à partir de la valeur d'inductance aller-retour ; et

caractérisé par l'étape ci-dessous consistant à :
réduire la tension continue à fournir au second circuit convertisseur à une tension inférieure à la tension continue lorsque le moteur est entraîné.

# FIG. 1

EP 3 595 159 B1

# FIG. 2

# FIG. 3

(A)

TOTAL CABLE LENGTH L_cable
ROUND-TRIP INDUCTANCE Len_cable

SHORT
CIRCUIT LOCATION

CABLE LENGTH Len_sc TO SHORT CIRCUIT LOCATION
ROUND-TRIP INDUCTANCE Lsc

(B)

SHORT
CIRCUIT LOCATION

(C)

SHORT
CIRCUIT LOCATION

EP 3 595 159 B1

# FIG. 4

(A)

(B)

## FIG. 5

```
                    ┌──────────┐
                    │  START   │
                    └────┬─────┘
                         │
         ┌───────────────────────────────┐
S101 ────│  PERFORM MOTOR STOP           │
         │  ACTION                       │
         └───────────────┬───────────────┘
                         │
         ┌───────────────────────────────┐
S102 ────│  REDUCE DIRECT CURRENT        │
         │  VOLTAGE                      │
         └───────────────┬───────────────┘
                         │
         ┌───────────────────────────────┐
S103 ────│  SHORT CIRCUIT SITUATION      │
         │  INSPECTION                   │
         └───────────────┬───────────────┘
                         │
         ┌───────────────────────────────┐
S104 ────│  CALCULATE L VALUE            │
         └───────────────┬───────────────┘
                         │
         ┌───────────────────────────────┐
S105 ────│  DETERMINE SHORT CIRCUIT      │
         │  LOCATION                     │
         └───────────────┬───────────────┘
                         │
         ┌───────────────────────────────┐
S106 ────│  DISPLAY AND TRANSMIT         │
         │  RESULT                       │
         └───────────────┬───────────────┘
                         │
                    ┌──────────┐
                    │   END    │
                    └──────────┘
```

## FIG. 6

# FIG. 7

# FIG. 8

START

S201 — TURN ON BOTH ARMS

S202 — RESET TIMER Ts ← 0

S203 — MONITOR DET SIGNAL

S204 — IS OVERCURRENT DETECTED?  — Y → BRANCH (A)

N

S205 — Ts < TCTmin ?  Y

BRANCH (A) → S210 — Ical ← Iov  Tcal ← Ts

S206 — MEASURE CURRENT Imes

S207 — Imes ≥ Ipref ?  Y → BRANCH (B)

N

S208 — Ts < TCTmax ?  Y

S209 — Imes ≥ ILlim ?  Y → BRANCH (C)

N — BRANCH (D)

S211 — TURN OFF ONE ARM

S212 — Tcal ← Ts

S213 — MEASURE CURRENT Imes

S214 — Ical ← Imes

S216 — SHORT CIRCUIT DETECTION FLAG Fsc ← "N"

S215 — SHORT CIRCUIT DETECTION FLAG Fsc ← "Y"

S217 — TURN OFF BOTH ARMS

END

29

# FIG. 9

# FIG. 10

START

S231 — TURN ON UPPER ARM

S232 — SET VOLTAGE COMMAND PULSE WIDTH Tp TO MINIMUM VALUE

S233 — WAIT FOR CURRENT REDUCTION

S234 — TURN ON LOWER ARM DURING PERIOD Tp

S235 — MONITOR DET SIGNAL

BRANCH (A)

S236 — IS OVERCURRENT DETECTED?  Y

N

S237 — $Tp \leftarrow Tp + \Delta Tp1$

S246 — $Ical \leftarrow Iov$  $Tcal \leftarrow Tp$

S238 — $Tp < TCTmin$ ?  Y

N

S239 — WAIT FOR CURRENT REDUCTION

S240 — TURN ON LOWER ARM DURING PERIOD Tp

S241 — MEASURE CURRENT Imes

BRANCH (B)

S242 — $Imes \geq Ipref$ ?  Y

N

BRANCH (C)

S243 — $Tp \geq TCTmax$ ?  Y

N

S244 — $Tp \leftarrow Tp + \Delta Tp2$

S247 — $Ical \leftarrow Imes$  $Tcal \leftarrow Tp$

S245 — $Imes \geq ILim$ ?  Y

BRANCH (D)

N

S248 — SHORT CIRCUIT DETECTION FLAG Fsc ← "Y"

S249 — SHORT CIRCUIT DETECTION FLAG Fsc ← "N"

S250 — TURN OFF UPPER ARM

END

31

# FIG. 11

(A)

(B)

# FIG. 12

# FIG. 13

START

S301 — SELECT OF ACQUISITION METHOD OF L INFORMATION OF CABLE

CALCULATION BY CABLE DIAMETER

DIRECT INPUT

ACQUISITION BY MEASUREMENT

S311 — SELECT OPERATION SWITCH SET UPPER ARM: SWu, LOWER ARM: Swy

S303 — INPUT WIRE DIAMETER ΦC OF MOTOR CABLE

S312 — SHORT CIRCUIT CURRENT/SHORT CIRCUIT TIME MEASUREMENT

S304 — INPUT COVER DIAMETER ΦH OF MOTOR CABLE

CALCULATE L VALUE BY Ical, Tcal, INPUT TO L_cable

S313

S305 — CALCULATE ROUND-TRIP INDUCTANCE L_cable OF TOTAL CABLE LENGTH

INPUT ROUND-TRIP INDUCTANCE L_cable OF TOTAL CABLE LENGTH

S302

S306 — INPUT MOTOR CABLE LENGTH Len_cable

S307 — CALCULATE CONVERSION COEFFICIENT K_cable

S308 — STORE INPUT VALUES AND CALCULATION VALUES

END

# FIG. 14

# FIG. 15

# FIG. 16

151   152   153

DETERMINATION
RESULT → DECODER → LED
DRIVER

# FIG. 17

| (A) CODE | (B) DISPLAY PATTERN | (C) SHORT CIRCUIT LOCATION INFORMATION |
|---|---|---|
| A1 | A1 | ON CABLE NEAR POWER CONVERSION DEVICE (BETWEEN U-V PHASES) |
| A2 | A2 | ″ (BETWEEN V-W PHASES) |
| A3 | A3 | ″ (BETWEEN W-U PHASES) |
| b1 | b1 | ON CABLE NEAR MOTOR (BETWEEN U-V PHASES) |
| b2 | b2 | ″ (BETWEEN V-W PHASES) |
| b3 | b3 | ″ (BETWEEN W-U PHASES) |
| C1 | C1 | INSIDE MOTOR (BETWEEN U-V PHASES) |
| C2 | C2 | ″ (BETWEEN V-W PHASES) |
| C3 | C3 | ″ (BETWEEN W-U PHASES) |
| 00 ～ 99 | 00 ～ 99 | DISTANCE (m) FROM POWER CONVERSION DEVICE OF SHORT CIRCUIT LOCATION |

## FIG. 18

## FIG. 19

*FIG. 20*

## FIG. 21

START

S401 — PERFORM MOTOR STOP ACTION

S402 — Vdc ≤ Vdc1?  — Y

N

S403 — BE ON STANDBY FOR CERTAIN TIME

S404 — SHORT CIRCUIT SITUATION INSPECTION

S405 — CALCULATE L VALUE

S406 — DETERMINE SHORT CIRCUIT LOCATION

S407 — DISPLAY AND TRANSMIT RESULT

END

## FIG. 22

BLOCKING OF EXTERNAL POWER SOURCE

TIMING OF SHORT CIRCUIT SITUATION INSPECTION

VOLTAGE

Vdc0

DIRECT CURRENT VOLTAGE Vdc

Vdc1

TIME

## FIG. 23

```
            ( START )
               │
S410 ──  ┌──────────────────┐
         │  TURN OFF SW_BP   │
         └──────────────────┘
               │
         ┌─────▼────────┐
         │   ◇ Vdc ≥ Vdc1? ◇  ──── Y ──┐
S411 ──  │              N │             │
         │      ┌──────────▼─────────┐  │
S412 ──  │      │   BE ON STANDBY    │  │
         │      │  FOR CERTAIN TIME  │  │
         │      └────────────────────┘  │
         └──────────────────────────────┘
               │
         ┌──────────────────┐
S413 ──  │  SHORT CIRCUIT   │
         │   INSPECTION     │
         └──────────────────┘
               │
         ┌──────────────────┐
S414 ──  │ CALCULATE L VALUE │
         └──────────────────┘
               │
         ┌──────────────────┐
S415 ──  │ DETERMINE SHORT  │
         │ CIRCUIT LOCATION │
         └──────────────────┘
               │
         ┌──────────────────┐
S416 ──  │   DISPLAY AND    │
         │ TRANSMIT RESULT  │
         └──────────────────┘
               │
             ( END )
```

## FIG. 24

INPUTTING OF        TIMING OF SHORT CIRCUIT
EXTERNAL POWER      SITUATION INSPECTION

VOLTAGE

Vdc0

DIRECT CURRENT
VOLTAGE
Vdc

Vdc1

TIME

EP 3 595 159 B1

## FIG. 25

## FIG. 26

## FIG. 27

# FIG. 28

551

552

[Result of short circuit detection]

Parts    | Cable |  /  Motor

Detail Info. :  Inverter side

Position:    3.5 m from inverter

Phase:    "U-V"

*FIG. 29*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10023795 A
- JP 2016226243 A

- JP H0666901 A